# EUROPEAN PATENT APPLICATION

(11) **EP 4 668 316 A1**
(43) Date of publication of application: **24.12.2025**
(21) Application number: 24779854.9
(22) Date of filing: 21.03.2024
(51) Int. Cl.: H01L 21/301, B23K 26/364

(54) **WORKPIECE MACHINING METHOD**

(30) Priority: 31.03.2023 JP 2023058063
(71) Applicant: Tokyo Seimitsu Co., Ltd., Hachioji-shi, Tokyo 192-8515 (JP)
(72) Inventor: HAYASHI, Hirokazu, Hachioji-shi, Tokyo 192-8515 (JP)
(74) Representative: Gill Jennings & Every LLP
(86) International application number: PCT/JP2024/011067
(87) International publication number: WO 2024/203734

(57) **Abstract**

This workpiece processing method is a workpiece processing method for performing hollowing-out processing of a portion between two grooves formed in a workpiece and includes: a first step of applying a first laser beam having a non-circular beam spot to the portion between the two grooves on the workpiece to which a processing feed is applied relatively along the two grooves to perform hollowing-out processing of the portion between the two grooves; and a second step of applying a second laser beam having a non-circular beam spot to the portion between the two grooves which is hollowed out with the first laser beam on the workpiece to which a processing feed is applied relatively along the two grooves to further perform hollowing-out processing of the portion between the two grooves. In the first step, the first laser beam is applied in a state in which a longitudinal direction of the beam spot is inclined with respect to a proceeding direction of the processing such that a processing width corresponds to a space between the two grooves. In the second step, the second laser beam is applied in a state in which a longitudinal direction of the beam spot is inclined in a direction opposite to that of the first laser beam with respect to a proceeding direction of the processing such that a processing width corresponds to a space between the two grooves.

## Description

### TECHNICAL FIELD

The present invention relates to a workpiece processing method, and more particularly to a workpiece processing method for performing hollowing-out processing of a portion between two grooves formed in a workpiece. Priority is claimed on Japanese Patent Application No. 2023-058063, filed March 31, 2023, the content of which is incorporated herein by reference.

### BACKGROUND ART

When a semiconductor wafer using a Low-k (low dielectric constant) film as an interlayer insulating film is diced into chips using a normal blade dicer, there is a problem that film peeling (delamination) occurs.

Patent Document 1 proposes processing two grooves along a street and performing hollowing-out processing of a portion between the two grooves with a laser beam to remove a laminated body including a Low-k film from the street. In addition, Patent Document 1 proposes adjusting a processing width in the hollowing-out processing by making the shape of a beam spot non-circular, such as rectangular, and rotating the beam spot around an optical axis.

### Citation List

### Patent Document

Patent Document 1: Japanese Unexamined Patent Application, First Publication No. 2021-192922

### SUMMARY OF INVENTION

### Technical Problem

However, in order to adjust the processing width, when the processing is performed in a state in which a non-circular beam spot is inclined, debris may be unevenly adhered in the groove being processed, resulting in a problem of reduced processing quality.

The present invention has been made in view of the above circumstances, and an object of the present invention is to provide a workpiece processing method by which a workpiece can be processed with high quality.

### Solution to Problem

According to a first aspect for solving the above-described problem, there is provided a workpiece processing method for performing hollowing-out processing of a portion between two grooves formed in a workpiece, the method including: a first step of applying a first laser beam having a non-circular beam spot to the portion between the two grooves on the workpiece to which a processing feed is applied relatively along the two grooves to perform hollowing-out processing of the portion between the two grooves; and a second step of applying a second laser beam having a non-circular beam spot to the portion between the two grooves which is hollowed out with the first laser beam on the workpiece to which a processing feed is applied relatively along the two grooves to further perform hollowing-out processing of the portion between the two grooves, in which, in the first step, the first laser beam is applied in a state in which a longitudinal direction of the beam spot is inclined with respect to a proceeding direction of the processing such that a processing width corresponds to a space between the two grooves, and in which, in the second step, the second laser beam is applied in a state in which a longitudinal direction of the beam spot is inclined in a direction opposite to that of the first laser beam with respect to a proceeding direction of the processing such that a processing width corresponds to a space between the two grooves.

According to a second aspect, in the workpiece processing method according to the first aspect, the beam spot of the first laser beam and the beam spot of the second laser beam are inclined in directions opposite to each other and at the same angle.

According to a third aspect, in the workpiece processing method according to the first or second aspect, in a case in which the processing feed is applied at least twice, the first step is executed in a first processing feed, and the second step is executed in a second processing feed.

According to a fourth aspect, in the workpiece processing method according to the third aspect, the first step and the second step are alternately executed in third and subsequent processing feeds.

According to a fifth aspect, in the workpiece processing method according to the fourth aspect, in a case in which the processing feed is applied an odd number of times, the first step is executed in a state in which intensity of the first laser beam is set lower in a last processing feed than in the first processing feed.

According to a sixth aspect, in the workpiece processing method according to any one of the first to fifth aspects, intensities of the first laser beam and the second laser beam are changed for each processing feed.

According to a seventh aspect, in the workpiece processing method according to the first or second aspect, the first step and the second step are executed in a single processing feed.

According to an eighth aspect, in the workpiece processing method according to the seventh aspect, the first step and the second step are executed in a single processing feed while the first laser beam and the second laser beam are emitted from the same condensing lens.

According to a ninth aspect, in the workpiece processing method according to the seventh aspect, the first step and the second step are executed in a single processing feed while the first laser beam and the second laser beam are emitted from different condensing lenses.

According to a tenth aspect, the workpiece processing method according to any one of the first to ninth aspects further includes a step of applying a pair of third laser beams on the workpiece to which a processing feed is applied relatively to process the two grooves.

According to an eleventh aspect, in the workpiece processing method according to any one of the first to tenth aspects, the beam spots of the first laser beam and the second laser beam are linear, rectangular, or elliptical.

### Advantageous Effects of Invention

According to the present invention, a workpiece can be processed with high quality.

### BRIEF DESCRIPTION OF THE DRAWINGS

[FIG. 1] A plan view showing an example of an object to be processed.
[FIG. 2] A view showing an outline of a processing process of a groove.
[FIG. 3] A view showing an example of a method for adjusting a space between laser beams.
[FIG. 4] A view showing an example of a method for adjusting a processing width.
[FIG. 5] A conceptual view of debris adhesion.
[FIG. 6] A schematic view showing an example of a workpiece processing apparatus.
[FIG. 7] A schematic view showing an example of a hardware configuration of a control device.
[FIG. 8] A schematic view showing an embodiment of a laser processing head.
[FIG. 9] A schematic view showing an example of a configuration of an edge cutting laser beam generating unit.
[FIG. 10] A schematic view showing an example of a configuration of a hollowing-out laser beam generating unit.
[FIG. 11] A view showing an outline of adjustment of the processing width.
[FIG. 12] A conceptual view showing processing of a wiring layer removal groove.
[FIG. 13] A conceptual view showing a change in a cross-sectional shape of the wiring layer removal groove.
[FIG. 14] A flowchart showing a flow of a processing process of a wafer.
[FIG. 15] A view showing an example of a laser processing head.
[FIG. 16] A view showing another example of a laser processing head.
[FIG. 17] A view showing an example of a laser processing head.
[FIG. 18] A schematic view showing an example of a configuration of a hollowing-out laser beam generating unit.
[FIG. 19] A conceptual view showing processing of a wiring layer removal groove.
[FIG. 20] A flowchart showing a flow of a processing process of a wafer.

### DESCRIPTION OF EMBODIMENTS

Preferred embodiments of the present invention will now be described with reference to the accompanying drawings.

### [First embodiment]

Here, a case in which the present invention is applied to an apparatus that removes a wiring layer (a laminated body) including a Low-k film from a street before dicing of a semiconductor wafer that uses the Low-k film as an interlayer insulating film will be described as an example. The wafer is an example of a workpiece.

The Low-k film serving as an interlayer insulating film is made of a Low-k material (a material with a low dielectric constant). The Low-k material includes, for example, inorganic materials such as SiO₂, SiOC, and SiLK, organic materials that are polymers such as polyimide, parylene, and polytetrafluoroethylene, porous silica materials such as methyl-containing polysiloxane, and the like.

### [Outline of processing]

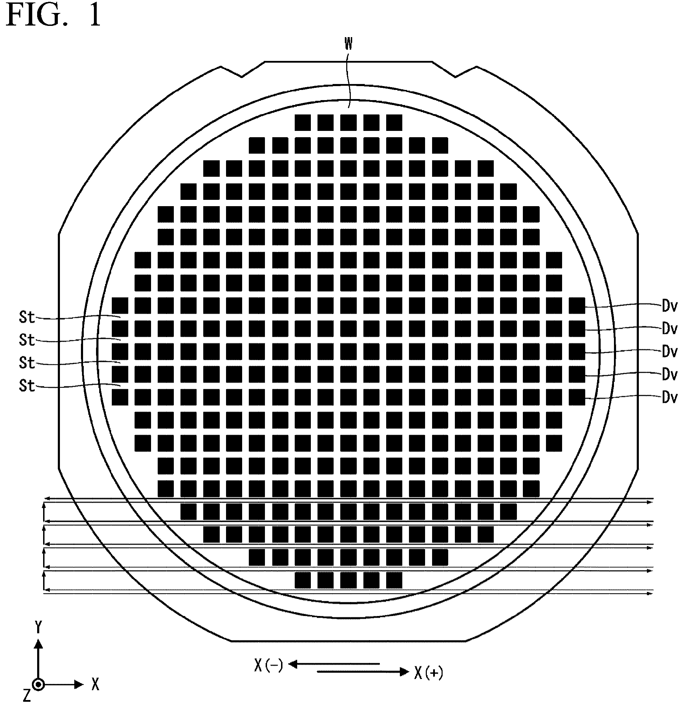

FIG. 1 is a plan view showing an example of an object to be processed.

As shown in FIG. 1, a semiconductor wafer W to be processed has devices Dv formed in lattice-like areas partitioned by a plurality of streets St (predetermined division lines). In the wafer W using a Low-k film as an interlayer insulating film, the Low-k film is present across the street St between the adjacent devices Dv. A predetermined groove is processed for each street St by ablation processing using a laser beam, thereby removing a wiring layer including the Low-k film from the street St.

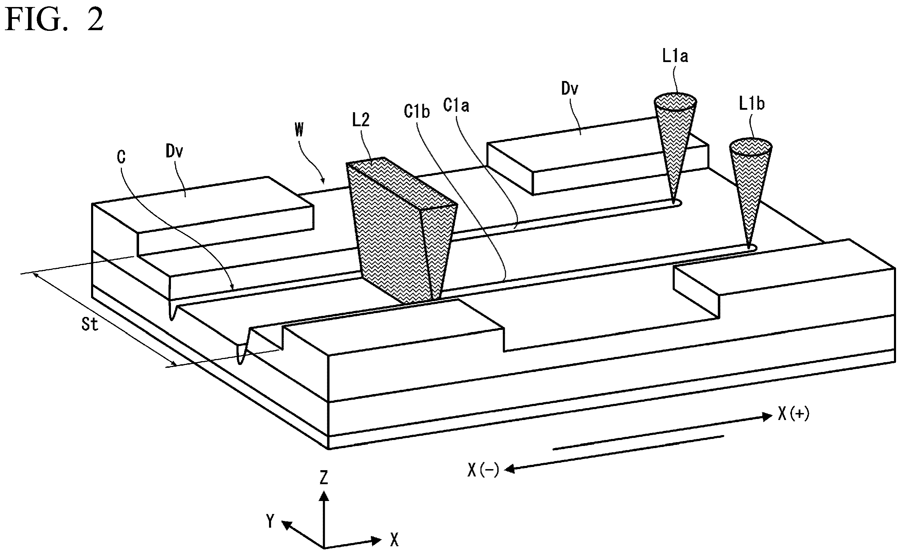

FIG. 2 is a view showing an outline of a processing process of a groove.

As shown in FIG. 2, a predetermined groove C is processed along the street St, and the wiring layer including the Low-k film is removed from the street St. At that time, processing of cutting edges on both sides of the groove C and processing of hollowing out the inside of the groove C, that is, hollowing-out processing, are dividedly performed to process the groove C. Hereinafter, the processing of cutting the edges on both sides of the groove C will be referred to as "edge cutting processing," and the processing of hollowing out the inside of the groove C will be referred to as "hollowing-out processing."

The edge cutting processing is performed by applying a pair of laser beams L1a and L1b along the street St and processing two grooves C1a and C1b, which are parallel to each other, along the street St. The two grooves C1a and C1b are processed with a space corresponding to a width of the groove C to be processed in a Y direction. In addition, the two grooves C1a and C1b are processed to a depth corresponding to a depth of the groove C to be processed in a Z direction.

The hollowing-out processing is performed by applying the laser beam L2 to a portion between the two grooves C1a and C1b formed by the edge cutting processing. The hollowing-out processing may be executed a plurality of times as necessary.

By combining the edge cutting processing and the hollowing-out processing, a single groove C having a predetermined width and a predetermined depth is finally formed along the street St.

If the groove C is processed using a laser beam with an output capable of removing the Low-k film all at once, there is a risk that the film may peel off. However, the groove C is processed by dividedly performing the edge cutting processing and the hollowing-out processing as described above, and thus the occurrence of film peeling can be suppressed.

### [Adjustment of processing width]

As described above, in the edge cutting processing, two grooves C1a and C1b are processed with the space corresponding to the width of the groove C to be processed in the street St. To change the space between the two grooves C1a and C1b to be processed, it is necessary to change a space between the pair of laser beams L1a and L1b in a direction perpendicular to a proceeding direction of the processing.

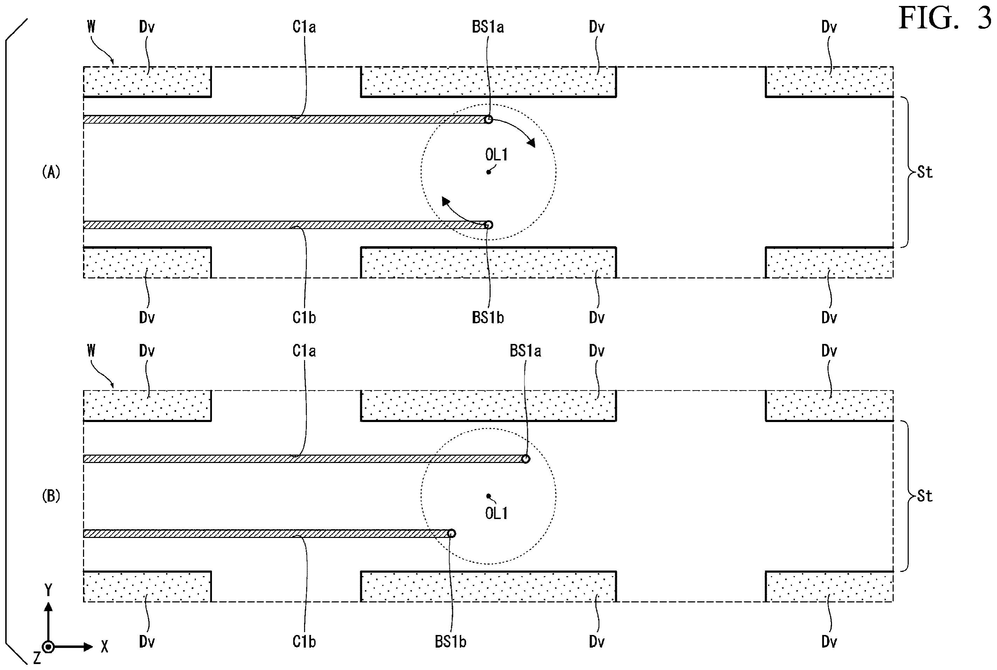

FIG. 3 is a view showing an example of a method for adjusting the space between the pair of laser beams.

FIG. 3 shows an example in which the space in the direction perpendicular to the proceeding direction of the processing is adjusted by rotating beam spots BS1a and BS1b, which are the applying positions of the pair of laser beams L1a and L1b, around a symmetric axis OL1.

FIG. 3A shows an example of a case in which the space between the pair of laser beams L1a and L1b is set to the maximum. FIG. 3B shows an example of a case in which the space between the pair of laser beams L1a and L1b is narrowed.

As shown in FIG. 3A, when the beam spots BS1a and BS1b of the pair of laser beams L1a and L1b are disposed side by side in the direction perpendicular to the proceeding direction of the processing (a direction in which the two grooves C1a are C1b are processed; an X direction in FIG. 3), the space between the two grooves C1a and C1b to be processed is maximized.

In addition, as shown in FIG. 3B, the space in the direction perpendicular to the proceeding direction of the processing can be changed by rotating the positions of the beam spots BS1a and BS1b, which are the applying positions of the pair of laser beams L1a and L1b, around the symmetric axis OL1.

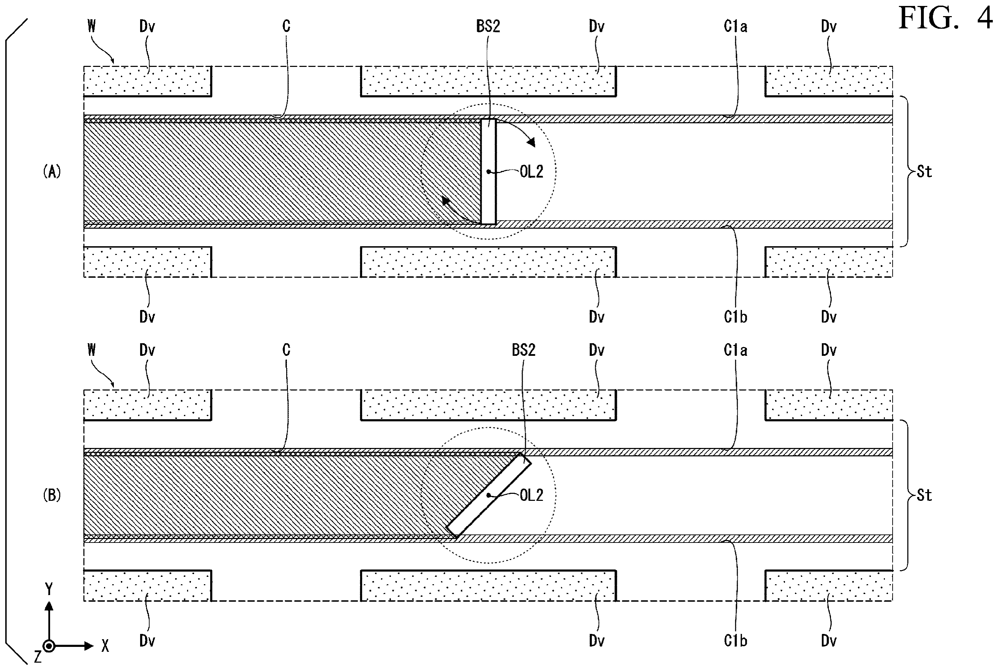

FIG. 4 is a view showing an example of a method for adjusting the processing width of the laser beam for hollowing-out processing.

FIG. 4 shows an example of a case in which the hollowing-out processing is performed using the laser beam L2 having a rectangular beam spot.

FIG. 4A shows an example of a case in which the processing width is set to the maximum. FIG. 4B shows an example of a case in which the processing width is narrowed.

As shown in FIG. 4A, when a longitudinal direction of a rectangular beam spot BS2 is perpendicular to the proceeding direction of the processing (the X direction in FIG. 4), the processing width is maximum.

In addition, as shown in FIG. 4B, the processing width can be changed by rotating the laser beam L2 around an optical axis OL2.

In this manner, the processing width of the laser beam L2 for hollowing-out processing can be adjusted by rotating the laser beam L2 around the optical axis OL2.

Except a case in which the processing width is set to the maximum, the processing is performed in a state in which the beam spot BS2 of the laser beam L2 for hollowing-out processing is inclined with respect to the proceeding direction of the processing (see FIG. 4B).

However, when the processing is performed in a state in which the longitudinal direction of the non-circular beam spot is inclined with respect to the proceeding direction of the processing, debris may be unevenly adhered in the groove being processed. Here, "the longitudinal direction of the beam spot is inclined with respect to the proceeding direction of the processing" means that the longitudinal direction of the beam spot is inclined from a state in which the longitudinal direction of the beam spot is perpendicular to the proceeding direction of the processing. Therefore, the longitudinal direction of the beam spot is at an angle with respect to the proceeding direction of the processing or the direction perpendicular to the proceeding direction of the processing. The longitudinal direction of the beam spot is a direction of a long side in a case in which the shape of the beam spot is a rectangular shape. In addition, in a case in which the shape of the beam spot is linear shape, the longitudinal direction is a direction of a straight line. In addition, in a case in which the shape of the beam spot is elliptical shape, the longitudinal direction is a direction of a major axis.

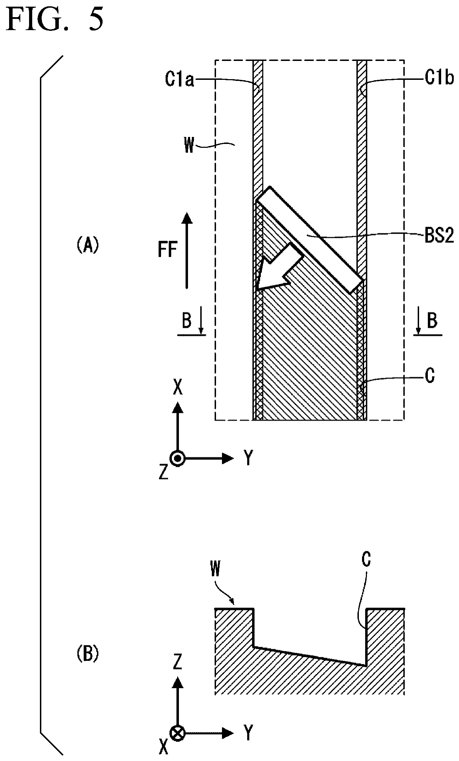

FIG. 5 is a conceptual view of debris adhesion.

FIG. 5A shows an example of a case in which the processing is performed in a state in which the beam spot is inclined. In FIG. 5A, the beam spot BS2 of the laser beam L2 moves relatively to the wafer W in a direction of an arrow indicated by a reference sign FF to perform the processing. That is, the arrow FF indicates the proceeding direction of the processing. FIG. 5B shows a cross section of the hollowing-out processed groove (cross section B-B in FIG. 5A).

When the processing is performed in a state in which the longitudinal direction of the beam spot BS2 of the laser beam L2 is inclined with respect to the proceeding direction of the processing (the X direction in FIG. 5A), the debris is scattered unevenly to one side of the groove C. Specifically, most of the debris is scattered in a direction perpendicular to the inclination of the beam spot BS2 (in a direction of a white arrow in FIG. 5A). As a result, as shown in FIG. 5B, the debris is unevenly adhered to one side of the groove C, causing the processed shape of the groove C to become uneven. This unevenness reduces the processing quality of the groove C.

Therefore, in the present embodiment, the hollowing-out processing is executed dividedly in two times, and the direction in which the beam spot BS2 is inclined is changed between the first processing and the second processing, thereby preventing the debris from adhering unevenly.

The workpiece processing method and an apparatus used for the processing (a workpiece processing apparatus) according to the present embodiment will be described below.

In the following description, the pair of laser beams L1a and L1b used for the edge cutting processing will be referred to as "edge cutting laser beams L1a and L1b," and the laser beam L2 used for the hollowing-out processing will be referred to as a "hollowing-out laser beam L2" to distinguish between the two. In addition, the two grooves C1a and C1b processed by the edge cutting processing are referred to as "edge cut grooves C1a and C1b," and the groove C processed by the edge cutting processing and the hollowing-out processing is referred to as a "wiring layer removal groove C" to distinguish between the two. The two edge cut grooves C1a and C1b processed by the edge cutting processing are an example of two grooves formed in the workpiece. In addition, the pair of edge cutting laser beams L1a and L1b are an example of a third laser beam.

### [Workpiece processing apparatus]

### [Apparatus configuration]

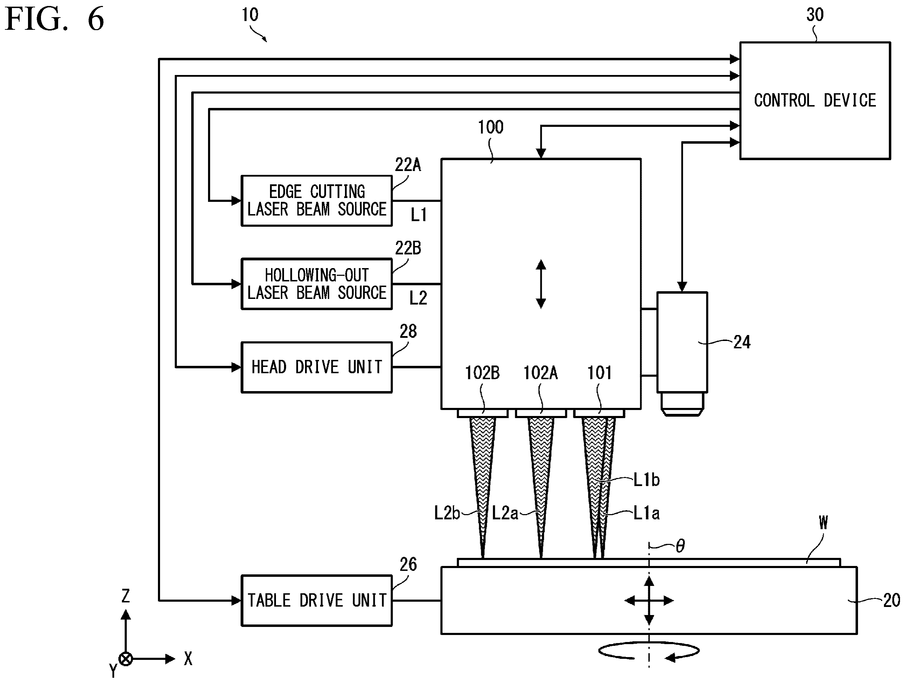

FIG. 6 is a schematic view showing an example of the workpiece processing apparatus. **In** the figure, XYZ are three axes that are perpendicular to each other. In the present embodiment, a plane including an X axis and a Y axis is defined as a horizontal plane, and the X direction and the Y direction are defined as a horizontal direction. In addition, the Z direction is defined as a vertical direction (an up-down direction).

The workpiece processing apparatus 10 of the present embodiment is provided as an apparatus that processes the wiring layer removal groove for each street in a single processing feed (so-called one pass). In other words, the workpiece processing apparatus 10 of the present embodiment is provided as an apparatus that performs the edge cutting processing, the first hollowing-out processing, and the second hollowing-out processing during a single processing feed. For this reason, the workpiece processing apparatus 10 of the present embodiment has a configuration in which the hollowing-out laser beam can be emitted twice. Hereinafter, as necessary, the hollowing-out laser beam L2a used in the first hollowing-out processing will be referred to as a "first hollowing-out laser beam L2a," and the hollowing-out laser beam L2b used in the second hollowing-out processing will be referred to as a "second hollowing-out laser beam L2b" to distinguish between the two. The first hollowing-out laser beam L2a is an example of a first laser beam. In addition, the second hollowing-out laser beam L2b is an example of a second laser beam.

As shown in FIG. 6, the workpiece processing apparatus 10 includes a table 20, an edge cutting laser beam source 22A, a hollowing-out laser beam source 22B, a laser processing head 100, a microscope 24, a table drive unit 26, a head drive unit 28, a control device 30, and the like.

The table 20 holds the wafer W. In addition, under the control of the control device 30, the table 20 is driven by the table drive unit 26 to move in the X direction and the Y direction. The X direction is a processing feed direction and the proceeding direction of the processing. The street St to be processed is set to be parallel to the X direction. In addition, under the control of the control device 30, the table 20 is driven by the table drive unit 26 to rotate around a θ axis. The θ axis passes through the center of the table 20 and is parallel to the Z axis.

The edge cutting laser beam source 22A supplies the laser beam L1 used for the edge cutting processing to the laser processing head 100. This laser beam L1 is a pulsed laser beam having conditions suitable for the edge cutting processing, for example, conditions in which a wavelength, a pulse width, a repetition frequency, and the like are adjusted.

The hollowing-out laser beam source 22B supplies the laser beam L2 used for the hollowing-out processing to the laser processing head 100. This laser beam L2 is a pulsed laser beam having conditions suitable for the hollowing-out processing, for example, conditions in which a wavelength, a pulse width, a repetition frequency, and the like are adjusted.

The laser processing head 100 has a predetermined laser optical system and emits the pair of edge cutting laser beams L1a and L1b and the first hollowing-out laser beam L2a and the second hollowing-out laser beam L2b toward the wafer W on the table 20. As described above, the edge cutting laser beams L1a and L1b are laser beams used for the edge cutting processing, and the hollowing-out laser beams L2a and L2b are laser beams used for the hollowing-out processing. Each of the laser beams L1a, L1b, L2a, and L2b is emitted vertically downward toward the wafer W on the table 20.

The laser processing head 100 has three emission ports for the laser beam. One is an edge cutting emission port 101 from which the pair of edge cutting laser beams L1a and L1b are emitted. The other is a first hollowing-out emission port 102A from which the first hollowing-out laser beam L2a is emitted. The remaining one is a second hollowing-out emission port 102B from which the second hollowing-out laser beam L2b is emitted. The edge cutting emission port 101, the first hollowing-out emission port 102A, and the second hollowing-out emission port 102B are disposed side by side in a row along the processing feed direction of the wafer W in the order of the edge cutting emission port 101, the first hollowing-out emission port 102A, and the second hollowing-out emission port 102B. The laser processing head 100 including the laser optical system will be described in detail below.

Under the control of the control device 30, the laser processing head 100 is driven by the head drive unit 28 to move in the Z direction.

The microscope 24 captures an image of the wafer W held on the table 20. The microscope 24 is fixed to the laser processing head 100 and moves integrally with the laser processing head 100. The image captured by the microscope 24 is output to the control device 30. The control device 30 performs alignment, kerf checks, and the like on the basis of the images captured by the microscope 24.

The table drive unit 26 includes a guide mechanism that guides the table 20 in the X direction, a guide mechanism that guides the table 20 in the Y direction, bearings that rotatably support the table 20, and the like as guide mechanisms. **In** addition, the table drive unit 26 includes, as actuators, a motor that drives the table 20 in the X direction, a motor that drives the table 20 in the Y direction, a motor that rotatably drives the table 20, and the like. In addition, the table drive unit 26 includes, as sensors, a sensor that detects the position of the table 20 in the X direction, a sensor that detects the position of the table 20 in the Y direction, a sensor that detects the rotational position of the table 20, and the like. The table drive unit 26 is an example of a processing feed unit.

The head drive unit 28 includes a guide mechanism that guides the laser processing head 100 in the Z direction, a motor that drives the laser processing head 100 in the Z direction, a sensor that detects the position of the laser processing head 100 in the Z direction, and the like.

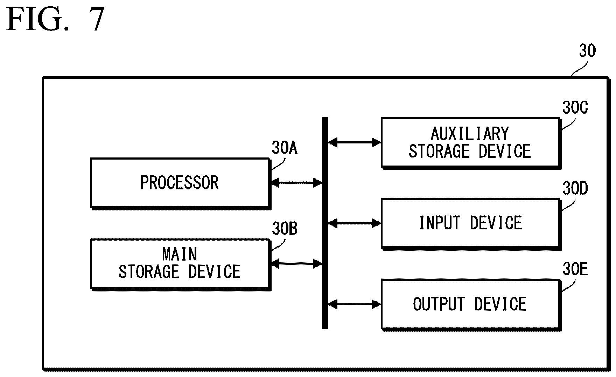

FIG. 7 is a schematic view showing an example of a hardware configuration of the control device.

The control device 30 includes a processor 30A, a main storage device 30B, an auxiliary storage device 30C, an input device 30D, and an output device 30E. That is, the control device 30 is constituted by a computer, and the computer functions as the control device 30 when the computer executes a predetermined program. The processor 30A is constituted by, for example, a central processing unit (CPU).

The main storage device 30B is constituted by, for example, a random access memory (RAM). The auxiliary storage device 30C is constituted by, for example, a hard disk drive (HDD), a solid state drive (SSD), or the like. The input device 30D includes a keyboard, a touch panel, and the like in addition to operation buttons. The output device 30E is constituted by, for example, a display (a display device). The input device 30D and the output device 30E may also be formed as a touch panel display.

The control device 30 comprehensively controls the operations of the edge cutting laser beam source 22A, the hollowing-out laser beam source 22B, the laser processing head 100, the microscope 24, the table drive unit 26, the head drive unit 28, and the like. The control device 30 is an example of a control unit.

### [Laser processing head]

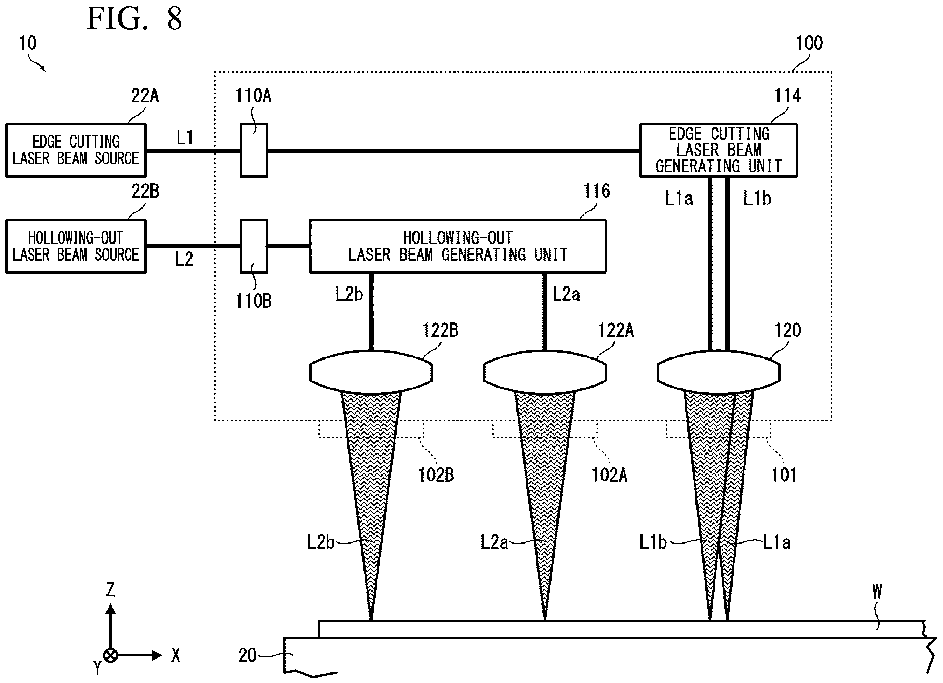

FIG. 8 is a schematic view showing an embodiment of the laser processing head.

As shown in FIG. 8, the laser processing head 100 is equipped with an edge cutting safety shutter 110A, a hollowing-out safety shutter 110B, an edge cutting laser beam generating unit 114, a hollowing-out laser beam generating unit 116, an edge cutting condensing lens 120, a first hollowing-out condensing lens 122A, a second hollowing-out condensing lens 122B, and the like.

The edge cutting safety shutter 110A, the edge cutting laser beam generating unit 114, and the edge cutting condensing lens 120 constitute a laser optical system for the edge cutting processing. This laser optical system generates the pair of edge cutting laser beams L1a and L1b from the laser beam L1 emitted from the edge cutting laser beam source 22A and emits the edge cutting laser beams L1a and L1b from the edge cutting emission port 101.

In addition, the hollowing-out safety shutter 110B, the hollowing-out laser beam generating unit 116, the first hollowing-out condensing lens 122A, and the second hollowing-out condensing lens 122B constitute a laser optical system for the hollowing-out processing. This laser optical system generates the first hollowing-out laser beam L2a and the second hollowing-out laser beam L2b from the laser beam L2 emitted from the hollowing-out laser beam source 22B and emits the first hollowing-out laser beam L2a and the second hollowing-out laser beam L2b from the corresponding emission ports. That is, the first hollowing-out laser beam L2a is emitted from the first hollowing-out emission port 102A, and the second hollowing-out laser beam L2b is emitted from the second hollowing-out emission port 102B.

### [Laser optical system for edge cutting processing]

As described above, the laser optical system for the edge cutting processing is constituted by the edge cutting safety shutter 110A, the edge cutting laser beam generating unit 114, and the edge cutting condensing lens 120.

The edge cutting safety shutter 110A is disposed on an optical path of the laser beam L1 that is incident on the laser processing head 100 from the edge cutting laser beam source 22A and opens and closes the optical path. When the edge cutting safety shutter 110A is closed, the incidence of the laser beam L1 from the edge cutting laser beam source 22A is blocked. The opening and closing of the edge cutting safety shutter 110A is controlled by the control device 30.

The edge cutting laser beam generating unit 114 generates the pair of edge cutting laser beams L1a and L1b from the laser beam L1 supplied from the edge cutting laser beam source 22A.

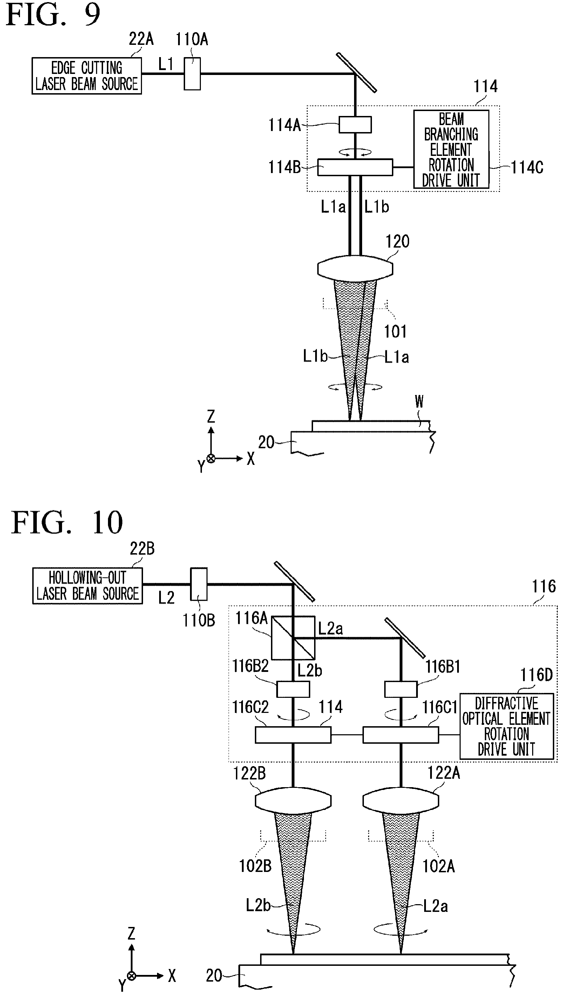

FIG. 9 is a schematic view showing an example of a configuration of the edge cutting laser beam generating unit.

As shown in FIG. 9, the edge cutting laser beam generating unit 114 includes an edge cutting high-speed shutter 114A, a beam branching element 114B, a beam branching element rotation drive unit 114C, and the like.

The edge cutting high-speed shutter 114A is disposed on an optical path of the laser beam L1 that is incident on the edge cutting laser beam generating unit 114 via the edge cutting safety shutter 110A. The edge cutting high-speed shutter 114A opens and closes the optical path under the control of the control device 30. When the edge cutting high-speed shutter 114A is closed, the incidence of the laser beam L1 on the edge cutting laser beam generating unit 114 is blocked. In addition, as a result, the emission of the edge cutting laser beams L1a and L1b from the edge cutting emission port 101 is also blocked. While the edge cutting safety shutter 110A safely and reliably blocks the incidence of the laser beam L1, the edge cutting high-speed shutter 114A functions as a shutter that temporarily stops the emission of the edge cutting laser beams L1a and L1b. For this reason, the edge cutting high-speed shutter 114A is constituted by a shutter that operates faster than the edge cutting safety shutter 110A. The opening and closing of the edge cutting high-speed shutter 114A is controlled by the control device 30.

The beam branching element 114B branches the incident beam (the laser beam L1) into two beams and generates the pair of edge cutting laser beams L1a and L1b. The beam branching element 114B is constituted by, for example, a diffractive optical element (DOE). The diffractive optical element is an optical element that can spatially branch the laser beam by utilizing the diffraction phenomenon of the beam. The diffractive optical element can change the laser beam into laser beams having various patterns and shapes. In the present embodiment, the beam branching element 114B branches the incident beam axially symmetrically into two beams with the optical axis of the edge cutting condensing lens 120 as a symmetric axis and generates the pair of edge cutting laser beams L1a and L1b. Therefore, the pair of edge cutting laser beams L1a and L1 emitted through the edge cutting condensing lens 120 are emitted axially symmetrically with the optical axis of the edge cutting condensing lens 120 as a symmetric axis. Therefore, the beam spots BS1a and BS1b are also applied axially symmetrically with the optical axis of the edge cutting condensing lens 120 as a symmetric axis. In addition to the diffractive optical element, for example, a refractive optical element (ROE), a Wollaston prism, or the like can be employed as the beam branching element 114B.

The beam branching element rotation drive unit 114C has an actuator and rotatably drives the beam branching element 114B. The beam branching element rotation drive unit 114C rotates the beam branching element 114B around the optical axis of the laser beam L1 that is incident on the beam branching element114B, that is, the optical axis of the edge cutting condensing lens 120. When the beam branching element rotation drive unit 114C rotates the beam branching element 114B, the beam spots BS1a and BS1b of the edge cutting laser beams L1a and L1b rotate around the optical axis of the edge cutting condensing lens 120. As a result, the space between the edge cut grooves C1a and C1b to be processed is adjusted. The driving of the beam branching element rotation drive unit 114C is controlled by the control device 30.

The edge cutting laser beam generating unit 114 may further include a means for adjusting the intensity of the edge cutting laser beams L1a and L1b (an intensity modulating means). For example, an acoustic optical deflector (AOD) or the like may be provided as the intensity modulating means.

The pair of edge cutting laser beams L1a and L1b generated by the edge cutting laser beam generating unit 114 are applied to the wafer W on the table 20 via the edge cutting condensing lens 120.

The edge cutting condensing lens 120 condenses the pair of edge cutting laser beams L1a and L1b generated by the edge cutting laser beam generating unit 114 at a predetermined position (a focal point) in the Z direction and applies the pair of edge cutting laser beams L1a and L1b to the wafer W on the table 20.

### [Laser optical system for hollowing-out processing]

As described above, the laser optical system for the hollowing-out processing is constituted by the hollowing-out safety shutter 110B, the hollowing-out laser beam generating unit 116, the first hollowing-out condensing lens 122A, and the second hollowing-out condensing lens 122B.

The hollowing-out safety shutter 110B is disposed on an optical path of the laser beam L2 that is incident on the laser processing head 100 from the hollowing-out laser beam source 22B and opens and closes the optical path. When the hollowing-out safety shutter 110B is closed, the incidence of the laser beam L2 from the hollowing-out laser beam source 22B is blocked. The opening and closing of the hollowing-out safety shutter 110B is controlled by the control device 30.

The hollowing-out laser beam generating unit 116 generates the first hollowing-out laser beam L2a and the second hollowing-out laser beam L2b from the laser beam L2 supplied from the hollowing-out laser beam source 22B.

FIG. 10 is a schematic view showing an example of a configuration of the hollowing-out laser beam generating unit.

As shown in FIG. 10, the hollowing-out laser beam generating unit 116 has a beam splitter 116A, a first hollowing-out high-speed shutter 116B1, a second hollowing-out high-speed shutter 116B2, a first diffractive optical element 116C1, a second diffractive optical element 116C2, a diffractive optical element rotation drive unit 116D, and the like.

The beam splitter 116A splits the laser beam L2 that is incident on the hollowing-out laser beam generating unit 116 via the hollowing-out safety shutter 110B into two beams which are the first hollowing-out laser beam L2a and a second hollowing-out laser beam L2b.

The first hollowing-out high-speed shutter 116B1 is disposed on an optical path of the first hollowing-out laser beam L2a which is one of the two beams branched by the beam splitter 116A and opens and closes the optical path. The second hollowing-out high-speed shutter 116B2 is disposed on an optical path of the second hollowing-out laser beam L2b which is the other of the two beams branched by the beam splitter 116A and opens and closes the optical path. Each of the first hollowing-out high-speed shutter and the second hollowing-out high-speed shutter 116B1 and 116B2 is constituted by a shutter that operates faster than the hollowing-out safety shutter 110B, and the opening and closing thereof is controlled individually by the control device 30.

The first diffractive optical element 116C1 converts the shape of the beam spot BS2a of the first hollowing-out laser beam L2a into a predetermined shape. The converted shape is a non-circular shape. As an example, in the present embodiment, the shape is converted into a rectangular shape.

The second diffractive optical element 116C2 converts the shape of the beam spot BS2b of the second hollowing-out laser beam L2b into a predetermined shape. The converted shape is a non-circular shape. As an example, in the present embodiment, the shape is converted into a rectangular shape.

The shape of the beam spot BS2a of the first hollowing-out laser beam L2a converted by the first diffractive optical element 116C1 and the shape of the beam spot BS2b of the second hollowing-out laser beam L2b converted by the second diffractive optical element 116C2 are the same.

The diffractive optical element rotation drive unit 116D has an actuator and rotatably drives the first diffractive optical element 116C1 and the second diffractive optical element 116C2. The diffractive optical element rotation drive unit 116D rotates the first diffractive optical element 116C1 and the second diffractive optical element 116C2 in directions opposite to each other. Thus, for example, in a case in which the first diffractive optical element 116C1 rotates clockwise, the second diffractive optical element 116C2 rotates counterclockwise. In addition, the diffractive optical element rotation drive unit 116D rotates the first diffractive optical element 116C1 and the second diffractive optical element 116C2 by the same amount. Thus, for example, in a case in which the first diffractive optical element 116C1 rotates 10 degrees clockwise, the second diffractive optical element 116C2 rotates 10 degrees counterclockwise.

The first diffractive optical element 116C1 and the second diffractive optical element 116C2 are driven by the diffractive optical element rotation drive unit 116D and rotated around an optical axis.

When the first diffractive optical element 116C1 is rotated, the beam spot BS2a of the first hollowing-out laser beam L2a is rotated around the optical axis of the first hollowing-out condensing lens 122A. As a result, it is possible to adjust the processing width when the hollowing-out processing is performed with the first hollowing-out laser beam L2a.

When the second diffractive optical element 116C2 is rotated, the beam spot BS2b of the second hollowing-out laser beam L2b is rotated around the optical axis of the second hollowing-out condensing lens 122B. As a result, it is possible to adjust the processing width when the hollowing-out processing is performed with the second hollowing-out laser beam L2b.

The driving of the diffractive optical element rotation drive unit 116D is controlled by the control device 30.

The hollowing-out laser beam generating unit 116 may also include a means for adjusting the intensity of the first hollowing-out laser beam L2a and the second hollowing-out laser beam L2b (an intensity modulating means, a means for adjusting the intensity distribution, and the like. For example, an acoustic optical deflector may be provided on the optical path of each of the laser beams L2a and L2b as a means for individually adjusting the intensity of each of the laser beams L2a and L2b. **In** addition, as a means for individually converting the intensity distribution of each of the laser beams L2a and L2b, for example, an optical element such as a diffractive optical element (DOE) or a refractive beam shaper may be provided on the optical path of each of the laser beams L2a and L2b. It is preferable that the intensity distribution of the first hollowing-out laser beam L2a and the second hollowing-out laser beam L2b used in the hollowing-out processing be in a top hat shape (also called a flat top shape). As a result, it is possible to process the bottom surface of the wiring layer removal groove C to be flat.

The first hollowing-out laser beam L2a and the second hollowing-out laser beam L2b generated by the hollowing-out laser beam generating unit 116 are applied to the wafer W on the table 20 via the first hollowing-out condensing lens 122A and the second hollowing-out condensing lens 122B, respectively.

The first hollowing-out condensing lens 122A and the second hollowing-out condensing lens 122B condense the first hollowing-out laser beam L2a and the second hollowing-out laser beam L2b respectively at a predetermined position (a focal point) in the Z direction and applies the first hollowing-out laser beam L2a and the second hollowing-out laser beam L2b to the wafer W on the table 20.

In the laser processing head 100 formed as described above, when the edge cutting safety shutter 110A is opened and the edge cutting high-speed shutter 114A is opened, the pair of edge cutting laser beams L1a and L1b are emitted from the edge cutting emission port 101. The pair of edge cutting laser beams L1a and L1b are applied vertically downward toward the wafer W on the table 20.

In addition, when the hollowing-out safety shutter 110B is opened and the first hollowing-out high-speed shutter 116B1 and the second hollowing-out high-speed shutter 116B2 are opened, the first hollowing-out laser beam L2a and the second hollowing-out laser beam L2b are emitted from the first hollowing-out emission port 102A and the second hollowing-out emission port 192B. The first hollowing-out laser beam L2a and the second hollowing-out laser beam L2b are each applied vertically downward toward the wafer W on the table 20.

### [Adjustment of processing width]

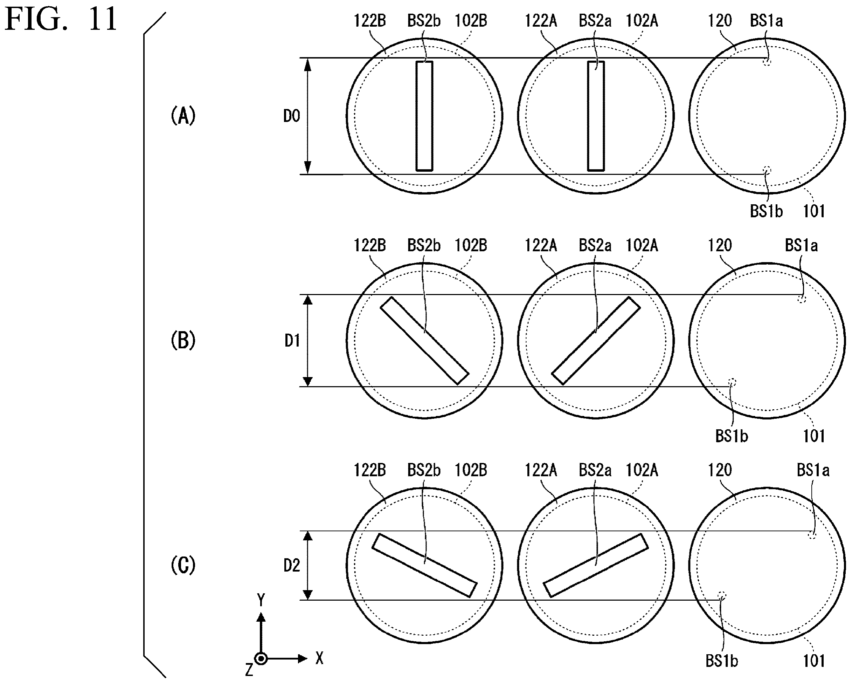

FIG. 11 is a view showing an outline of adjustment of the processing width.

FIGS. 11A to 11C show the states of the beam spots BS1a, BS1b, BS2a, and BS2b of the pair of edge cutting laser beams L1a and L1b, the first hollowing-out laser beam L2a, and the second hollowing-out laser beam L2b in cases in which the processing is performed with processing widths D0, D1, and D2, respectively.

The processing width D0 is the maximum processing width with which the processing can be performed. The processing widths D1 and D2 have a relationship of D2 < D1 < D0 with respect to the processing width D0.

When the processing is performed with the maximum processing width D0, as shown in FIG. 11A, the beam spots BS1a and BS1b of the pair of edge cutting laser beams L1a and L1b are disposed side by side in a direction (the Y direction) perpendicular to the feed direction of the processing. In addition, the beam spot BS2a of the first hollowing-out laser beam L2a and the beam spot BS2b of the second hollowing-out laser beam L2b are disposed such that the longitudinal directions thereof are perpendicular to the feed direction of the processing. In other words, each of the longitudinal direction of the beam spot BS2a and the longitudinal direction of the beam spot BS2b is not inclined.

The position of the beam branching element 114B in a case in which the processing is performed with the maximum processing width D0 is set as a reference position of the beam branching element 114B. Similarly, the position of the first diffractive optical element 116C1 in a case in which the processing is performed with the maximum processing width D0 is set as a reference position of the first diffractive optical element 116C1, and the position of the second diffractive optical element 116C2 in a case in which the processing is performed with the maximum processing width D0 is set as a reference position of the second diffractive optical element 116C2.

In a case in which the processing width is narrowed, the beam branching element 114B, the first diffractive optical element 116C1, and the second diffractive optical element 116C2 are each rotated from the reference position.

When the beam branching element 114B is rotated from the reference position, the positions of the beam spots BS1a and BS1b of the pair of edge cutting laser beams L1a and L1b are rotated around the optical axis of the edge cutting condensing lens 120, as shown in FIGS. 11B and 11C. As a result, the space between the edge cut grooves C1a and C1b processed by the pair of edge cutting laser beams L1a and L1b is changed. The space becomes narrower as the rotation angle from the reference position increases. The range of the rotation angle that can be set is greater than or equal to 0 degrees and less than 90 degrees.

In addition, when the first diffractive optical element 116C1 is rotated from the reference position, the beam spot BS2a of the first hollowing-out laser beam L2a is rotated (inclined) around the optical axis of the first hollowing-out condensing lens 122A, as shown in FIGS. 11B and 11C. As a result, the width (the processing width) with which the processing is performed using the first hollowing-out laser beam L2a is changed. The processing width becomes narrower as the rotation angle from the reference position increases. The range of the rotation angle that can be set is greater than or equal to 0 degrees and less than 90 degrees.

Similarly, when the second diffractive optical element 116C2 is rotated from the reference position, the beam spot BS2b of the second hollowing-out laser beam L2b is rotated (inclined) around the optical axis of the second hollowing-out condensing lens 122B, as shown in FIGS. 11B and 11C. As a result, the width (the processing width) with which the processing is performed using the second hollowing-out laser beam L2b is changed. The processing width becomes narrower as the rotation angle from the reference position increases. The range of the rotation angle that can be set is greater than or equal to 0 degrees and less than 90 degrees.

Here, as shown in FIGS. 11B and 11C, the beam spot BS2a of the first hollowing-out laser beam L2a and the beam spot BS2b of the second hollowing-out laser beam L2b are rotated in directions opposite to each other. Therefore, in a case in which the processing is performed such that the processing width is narrowed, the first hollowing-out laser beam L2a and the second hollowing-out laser beam L2b execute the hollowing-out processing in a state in which the beam spots BS2a and BS2b thereof are inclined in the opposite directions. In particular, in the present embodiment, the two beam spots BS2a and BS2b are inclined at symmetrical angles to execute the hollowing-out processing.

### [Operation of workpiece processing apparatus]

### [Basic operation]

As shown in FIG. 1, the workpiece processing apparatus 10 processes the wiring layer removal grooves C for each street St on the semiconductor wafer W on which a large number of devices Dv are formed and removes the wiring layer including the Low-k film from the streets St.

The wiring layer removal groove C is processed by feeding the wafer W in the X direction. As will be described below, in the present embodiment, a desired wiring layer removal groove C is processed in each street St in a single processing feed (one pass).

The wiring layer removal groove C is processed in sequence starting from the street St located at one end in the Y direction. When the processing of one street St is ended, the wafer W is fed in the Y direction (index feed) and the next street St is processed. When the processing of all the streets St extending in a first direction (the X direction in FIG. 1) is ended, the wafer W is rotated by 90 degrees. As a result, a street St extending in a second direction (the Y direction in FIG. 1) is disposed in the processing feed direction. In the same procedure, the wiring layer removal grooves C are processed in all the streets St extending in the second direction.

### [Details of processing operation of wiring layer removal groove]

As described above, in the workpiece processing apparatus 10 of the present embodiment, the wiring layer removal groove C is processed in each street St in a single processing feed.

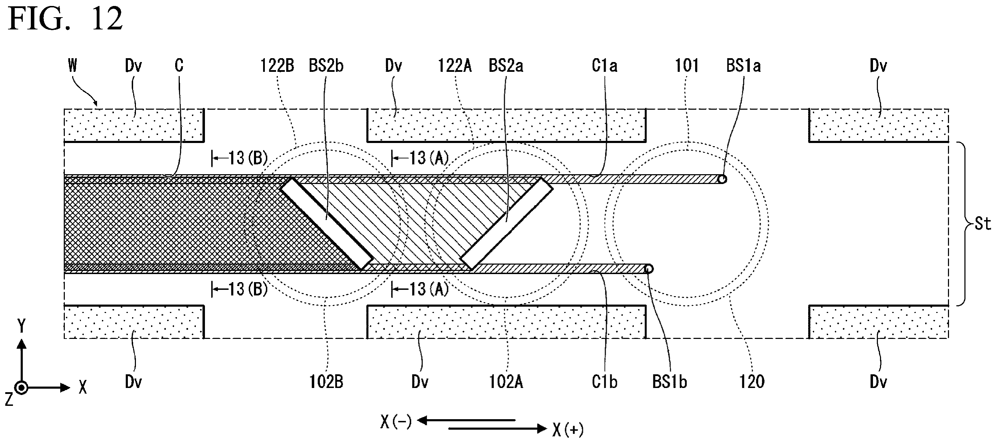

FIG. 12 is a conceptual view showing the processing of the wiring layer removal groove. FIG. 12 shows an example of the case in which the processing is performed such that the processing width is narrowed.

As described above, the edge cutting emission port 101 for the pair of edge cutting laser beams L1a and L1b, the first hollowing-out emission port 102A for the first hollowing-out laser beam L2a, and the second hollowing-out emission port 102B for the second hollowing-out laser beam L2b are disposed side by side in a row in the processing feed direction of the wafer W.

In a case in which the processing feed is applied to the wafer W in an X(-) direction in FIG. 12, first, the edge cutting processing is performed with the pair of edge cutting laser beams L1a and L1b. Through the edge cutting processing, the two edge cut grooves C1a and C1b are processed along the street St. Next, the first hollowing-out laser beam L2a is applied to a portion between the two edge cut grooves C1a and C1b, and the portion between the two edge cut grooves C1a and C1b is hollowing-out processed (first hollowing-out processing/a first step). Thereafter, the second hollowing-out laser beam L2b is further applied to the portion between the two edge cut grooves C1a and C1b. As a result, the portion between the two edge cut grooves C1a and C1b is further hollowing-out processed (second hollowing-out processing/a second step).

In this manner, in the workpiece processing apparatus 10 of the present embodiment, the hollowing-out processing is performed two times consecutively in a single processing feed.

Incidentally, in a case in which the processing is performed such that the processing width is narrowed, the beam spots BS2a and BS2b of the hollowing-out laser beams L2a and L2b are inclined with respect to the proceeding direction of the processing. When the processing is performed in a state in which the non-circular beam spots BS2a and BS2b are inclined, debris may be unevenly adhered in the groove being processed, resulting in an uneven processed shape.

However, in the workpiece processing apparatus 10 of the present embodiment, the hollowing-out processing is executed two times, and in each time, the processing is performed in a state in which the inclinations of the beam spots BS2a and BS2b are set in opposite directions, thereby suppressing the unevenness in the processed shape.

In a case in which the processing performed in a state in which the non-circular beam spot is inclined, the debris is unevenly adhered because the debris scatters in a direction perpendicular to the angle of the beam spot (see FIG. 5). By setting the inclinations of the beam spots BS2a and BS2b in opposite directions in two times of the processing, the unevenness can be cancelled out.

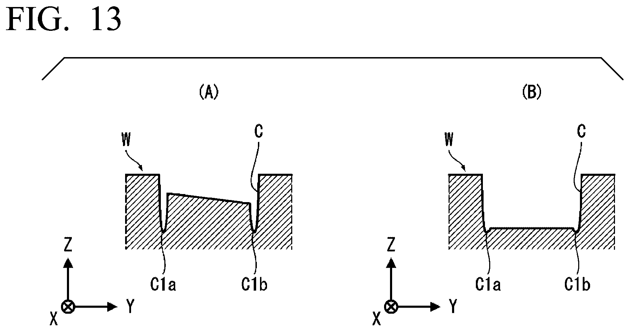

FIG. 13 is a conceptual view showing a change in a cross-sectional shape of the wiring layer removal groove.

FIG. 13A is a cross-sectional view along line 13(A)-13(A) of FIG. 12 and shows a cross-sectional shape of the wiring layer removal groove C after the first hollowing-out processing. In the first hollowing-out processing, the debris is unevenly adhered to one side of the groove in a width direction. In FIG. 13A, the debris is unevenly adhered toward the left side of the figure.

FIG. 13B is a cross-sectional view along line 13(B)-13(B) of FIG. 12 and shows a cross-sectional shape of the wiring layer removal groove C after the second hollowing-out processing. In the second hollowing-out processing, the debris is also unevenly adhered to one side in the width direction of the groove, but because the beam spot is inclined in the direction opposite to that in the first hollowing-out processing, the debris is adhered in the direction opposite to that in the first hollowing-out processing. As a result, the unevenness can be cancelled out, and the wiring layer removal groove C can be processed without any unevenness in the processed shape. In particular, in the present embodiment, the beam spots BS2a and BS2b of the two hollowing-out laser beams L2a and L2b have the same shape and are inclined at symmetric angles, and thus the unevenness can be appropriately cancelled out. Therefore, high quality processing can be achieved.

### [Processing process of wafer]

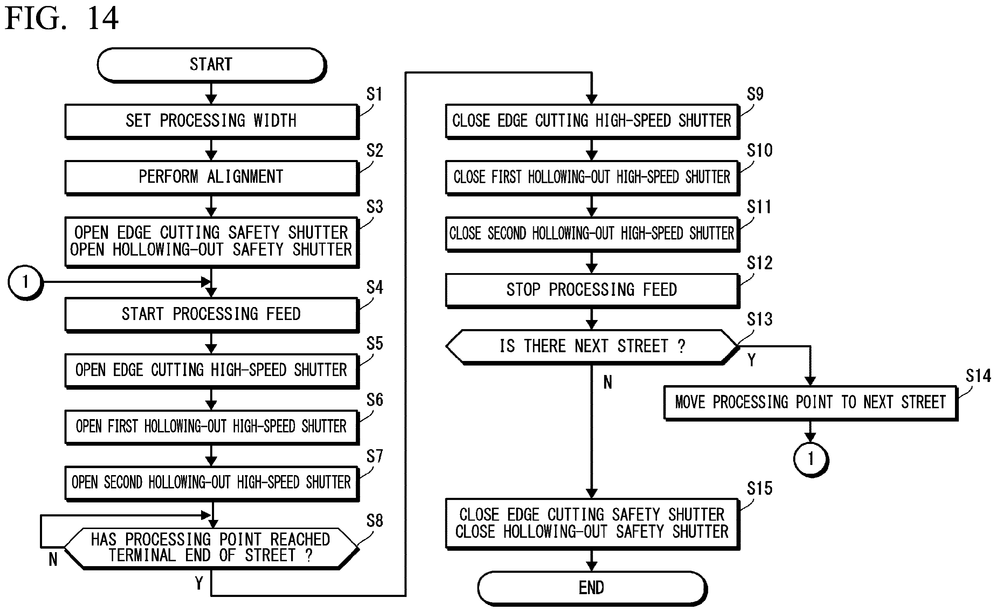

FIG. 14 is a flowchart showing a flow of a processing process of the wafer by the workpiece processing apparatus of the present embodiment.

It is assumed that the wafer W is already held on the table 20. In addition, it is assumed that the laser beam is supplied to the laser processing head 100 from the edge cutting laser beam source 22A and the hollowing-out laser beam source 22B. In addition, it is assumed that the edge cutting safety shutter 110A, the hollowing-out safety shutter 110B, the edge cutting high-speed shutter 114A, the first hollowing-out high-speed shutter 116B1, and the second hollowing-out high-speed shutter 116B2 are closed.

First, setting of the processing width (the width of the wiring layer removal groove C) is performed (step S1). The control device 30 receives the setting of the processing width from a user (an operator). The setting of the processing width can be received with the processing width as one item of the processing recipes (the processing conditions), for example.

The control device 30 performs setting of each unit such that the processing is performed with the set processing width. Specifically, the angle of the beam branching element 114B is set such that the edge cutting processing is performed with the set processing width. That is, the angle of the beam branching element 114B is set such that the two edge cut grooves C1a and C1b are processed with the space corresponding to the set processing width. In addition, the angles of the first diffractive optical element 116C1 and the second diffractive optical element 116C2 are set such that the hollowing-out processing is performed with the set processing width.

After the processing width is set, alignment is performed (step S2). That is, the position of the processing is aligned with respect to the street St to be processed. The alignment is performed by photographing the surface of the wafer W with the microscope 24.

After the alignment, the edge cutting safety shutter 110A and the hollowing-out safety shutter 110B are opened (step S3). As a result, the laser beam L1 used for the edge cutting processing is introduced into the laser processing head 100 from the edge cutting laser beam source 22A. In addition, the laser beam L2 used for hollowing-out processing is introduced into the laser processing head 100 from the hollowing-out laser beam source 22B.

Since the edge cutting high-speed shutter 114A is closed, the edge cutting laser beams L1a and L1b are not emitted. Similarly, since the first hollowing-out high-speed shutter 116B1 and the second hollowing-out high-speed shutter 162B2 are closed, the first hollowing-out laser beam L2a and the second hollowing-out laser beam L2b are not emitted.

In this way, the preparation before the processing is started is completed, and then the processing feed is started (step S4). As a result, the processing feed is applied to the wafer W along the street St. The direction in which the feed is applied is an X(-) direction in FIG. 1.

Next, the edge cutting high-speed shutter 114A is opened (step S5). As a result, the pair of edge cutting laser beams L1a and L1b are emitted from the edge cutting emission port 101 via the edge cutting condensing lens 120. The pair of emitted edge cutting laser beams L1a and L1b are applied to the wafer W on the table 20. As a result, the two edge cut grooves C1a and C1b are processed along the street St. The proceeding direction of the processing is an X(+) direction in FIG. 1. The two edge cut grooves C1a and C1b are processed with a predetermined space and with a predetermined depth.

Next, the first hollowing-out high-speed shutter 116B1 is opened (step S6). As a result, the first hollowing-out laser beam L2a is emitted from the first hollowing-out emission port 102A via the first hollowing-out condensing lens 122A. The first hollowing-out laser beam L2a is applied to a portion between the two edge cut grooves C1a and C1b which have been previously processed with the pair of edge cutting laser beams L1a and L1b. As a result, the portion between the two edge cut grooves C1a and C1b which have been previously processed is hollowing-out processed (the first hollowing-out processing/a first step).

Next, the second hollowing-out high-speed shutter 116B2 is opened (step S7). As a result, the second hollowing-out laser beam L2b is emitted from the second hollowing-out emission port 102B via the second hollowing-out condensing lens 122B. The second hollowing-out laser beam L2b is applied to the portion between the two edge cut grooves C1a and C1b which have been previously hollowing-out processed with the first hollowing-out laser beam L2a. As a result, the portion between the two edge cut grooves C1a and C1b is further hollowing-out processed (the second hollowing-out processing/a second step).

At this time, in a case in which the processing is performed in a state in which the beam spot is inclined, the processing is performed in a state in which the beam spot BS2b of the following second hollowing-out laser beam L2b is inclined in a direction opposite to the beam spot BS2a of the previous first hollowing-out laser beam L2a. As a result, it is possible to suppress the unevenness of the debris and to achieve high quality processing.

Thereafter, it is determined whether or not a processing point has reached the terminal end of the street St (step S8). When it is determined that the processing point has reached the terminal end of the street St, first, the edge cutting high-speed shutter 114A is closed (step S9). As a result, the emission of the pair of edge cutting laser beams L1a and L1b is stopped. In addition, as a result, the edge cutting processing is ended.

Next, the first hollowing-out high-speed shutter 116B1 is closed (step S10). As a result, the emission of the first hollowing-out laser beam L2a is stopped. In addition, as a result, the previous hollowing-out processing (the first hollowing-out processing/the first step) is ended.

Next, the second hollowing-out high-speed shutter 116B2 is closed (step S11). As a result, the emission of the second hollowing-out laser beam L2b is stopped. In addition, as a result, the following hollowing-out processing (the second hollowing-out processing/the second step) is ended. Thereafter, the processing feed is stopped (step S12).

Through the above series of steps, the processing of the wiring layer removal groove C for one street St is completed. Thereafter, it is determined whether or not there is a street St to be processed next (step S13).

In a case in which there is a street St to be processed next, the processing point moves to the next street St (step S14), and the processing of the next street St is performed in the same procedure (steps S4 to S13). That is, after the processing is returned to the feed start position in the processing feed direction, the wafer is fed in the Y direction, and the processing of the next street St is performed.

On the other hand, in a case in which there is no street St to be processed next, that is, in a case in which the processing for all the streets St is completed, the edge cutting safety shutter 110A and the hollowing-out safety shutter 110B are closed (step S15). Thereafter, the wafer W is retrieved from the table 20, and the processing process for the wafer W is completed.

In this manner, in the workpiece processing apparatus 10 of the present embodiment, the hollowing-out processing is executed two times, and in each time, the processing is performed in a state in which the inclinations of the beam spots BS2a and BS2b are set in opposite directions. As a result, it is possible to suppress the unevenness of the debris and to process a high-quality wiring layer removal groove C.

### [Modification example]

### [Laser processing head]

### [Number of hollowing-out emission port]

In the above-described embodiment, by providing the first hollowing-out emission port 102A and the second hollowing-out emission port 102B, which are two hollowing-out emission ports, in one laser processing head 100, it is possible to execute the hollowing-out processing two times in one pass. The number of hollowing-out emission ports is not limited to this. Furthermore, a plurality of hollowing-out emission ports may be provided. As a result, the hollowing-out processing can be performed a plurality of times in one pass. In this case, the direction in which the beam spot is inclined is changed for the processing in each time. Therefore, the inclination direction of the beam spot changes between an odd-numbered time and an even-numbered time. That is, in the processing in the odd-numbered time, the beam spot is inclined in the first direction, whereas in the processing in the even-numbered time, the beam spot is inclined in the second direction opposite to the first direction, and the processing is performed.

In addition, in a case in which the hollowing-out processing is performed a plurality of times, the intensity of the laser beam may be changed for each time. As a result, it is possible to perform processing in which the intensity of the laser beam is changed depending on the layer to be removed, for example.

In addition, the number of times of the hollowing-out processing is not limited to an even number, and the hollowing-out processing may be executed in an odd number of times. In this case, in the final processing, it is preferable to set the intensity of the laser beam to an intensity lower than that in the first processing so as to prevent the unevenness of the debris from occurring.

### [Arrangement of hollowing-out emission port]

Due to its nature, the hollowing-out emission port needs to be provided downstream of the edge cutting emission port in the proceeding direction of the processing.

In the laser processing head 100 of the above embodiment, the first hollowing-out emission port 102A and the second hollowing-out emission port 102B are disposed on one side of the edge cutting emission port 101. In this case, a wiring layer removal groove C can be processed only in a case in which a wafer W is fed in one direction (the X(-) direction). That is, the processing can be performed only in a forward path, and the processing cannot be performed in a backward path.

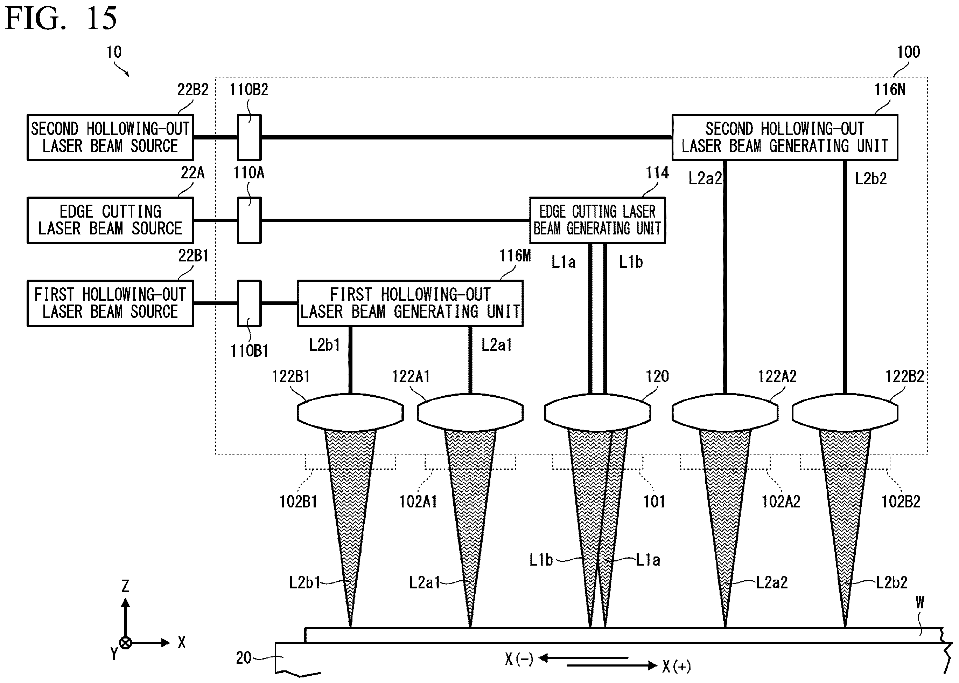

FIG. 15 is a view showing an example of a laser processing head that enables the processing in both the forward path and the backward path.

As shown in FIG. 15, a laser processing head 100 of the present example is provided with a total of four hollowing-out emission ports 102A1, 102B1, 102A2, and 102B2, that is, two on each of the two sides of an edge cutting emission port 101 in a processing feed direction. In FIG. 15, the two hollowing-out emission ports 102A1 and 102B1 located on the left side are referred to as a "first hollowing-out emission port 102A1 for the forward path" and a "second hollowing-out emission port 102B1 for the forward path," respectively, and the hollowing-out emission ports 102A2 and 102B2 located on the right side are referred to as a "first hollowing-out emission port 102A2 for the backward path" and a "second hollowing-out emission port 102B2 for the backward path," respectively, to distinguish between the emission ports.

In addition, in FIG. 15, the direction in which the wafer W is fed in the X(-) direction is referred to as the "forward path," and the direction in which the wafer W is fed in the X(+) direction is referred to as the "backward path."

The first hollowing-out emission port 102A1 for the forward path and the second hollowing-out emission port 102B1 for the forward path are emission ports for laser beams L2a1 and L2b1 used for the hollowing-out processing in the forward path. From the first hollowing-out emission port 102A1 for the forward path, a first hollowing-out laser beam L2a1 for the forward path is emitted. In addition, from the second hollowing-out emission port 102B1 for the forward path, a second hollowing-out laser beam L2b1 for the forward path is emitted.

The first hollowing-out emission port 102A2 for the backward path and the second hollowing-out emission port 102B2 for the backward path are emission ports for laser beams L2a2 and L2b2 used for the hollowing-out processing in the backward path. From the first hollowing-out emission port 102A2 for the backward path, a first hollowing-out laser beam L2a2 for the backward path is emitted. In addition, from the second hollowing-out emission port 102B2 for the backward path, a second hollowing-out laser beam L2b2 for the backward path is emitted.

The first hollowing-out laser beam L2a1 for the forward path and the second hollowing-out laser beamL2b1 for the forward path are generated by a first hollowing-out laser beam generating unit 116M. The first hollowing-out laser beam generating unit 116M generates the first hollowing-out laser beam L2a1 for the forward path and the second hollowing-out laser beam L2b1 for the forward path from the laser beam supplied from a first hollowing-out laser beam source 22B1 via a first hollowing-out safety shutter 110B1. The configuration of the first hollowing-out laser beam generating unit 116M is the same as that of the hollowing-out laser beam generating unit 116 in the above-described embodiment. Therefore, it is possible to rotate the beam spot of the first hollowing-out laser beam L2a1 for the forward path and the beam spot of the second hollowing-out laser beam L2b1 for the forward path. In a case in which the beam spot of the first hollowing-out laser beam L2a1 for the forward path and the beam spot of the second hollowing-out laser beam L2b1 for the forward path are rotated, the beam spots are rotated in the directions opposite to each other.

The first hollowing-out laser beam L2a1 for the forward path and the second hollowing-out laser beam L2b1 for the forward path which are generated by the first hollowing-out laser beam generating unit 116M are emitted from the first hollowing-out emission port 102A1 for the forward path and the second hollowing-out emission port 102B1 for the forward path via a first hollowing-out condensing lens 122A1 for the forward path and a second hollowing-out condensing lens 122B1 for the forward path, respectively.

The first hollowing-out laser beam L2a2 for the backward path and the second hollowing-out laser beamL2b2 for the backward path are generated by a second hollowing-out laser beam generating unit 116N. The second hollowing-out laser beam generating unit 116N generates the first hollowing-out laser beam L2a2 for the backward path and the second hollowing-out laser beam L2b2 for the backward path from the laser beam supplied from a first hollowing-out laser beam source 22B2 via a second hollowing-out safety shutter 110B2. The configuration of the second hollowing-out laser beam generating unit 116N is the same as that of the hollowing-out laser beam generating unit 116 in the above-described embodiment. Therefore, it is possible to rotate the beam spot of the first hollowing-out laser beam L2a2 for the backward path and the beam spot of the second hollowing-out laser beam L2b2 for the backward path. In a case in which the beam spot of the first hollowing-out laser beam L2a2 for the backward path and the beam spot of the second hollowing-out laser beam L2b2 for the backward path are rotated, the beam spots are rotated in the directions opposite to each other.

The first hollowing-out laser beam L2a2 for the backward path and the second hollowing-out laser beam L2b2 for the backward path which are generated by the second hollowing-out laser beam generating unit 116N are emitted from the first hollowing-out emission port 102A2 for the backward path and the second hollowing-out emission port 102B2 for the backward path via a first hollowing-out condensing lens 122A2 for the backward path and a second hollowing-out condensing lens 122B2 for the backward path, respectively.

According to the laser processing head 100 of the present example formed as described above, the wiring layer removal groove C can be processed in the wafer W in both the forward path and the backward path. In the forward path (the processing feed in the X(-) direction), the first hollowing-out laser beamL2a1 for the forward path and the second hollowing-out laser beam L2b1 for the forward path are emitted from the first hollowing-out emission port 102A1 for the forward path and the second hollowing-out emission port 102B1 for the forward path, respectively, to perform the hollowing-out processing. In the backward path (the processing feed in the X(+) direction), the first hollowing-out laser beamL2a2 for the backward path and the second hollowing-out laser beam L2b2 for the backward path are emitted from the first hollowing-out emission port 102A2 for the backward path and the second hollowing-out emission port 102B2 for the backward path, respectively, to perform the hollowing-out processing. As a result, two times of the hollowing-out processing can be performed in one pass in both the forward path and the backward path.

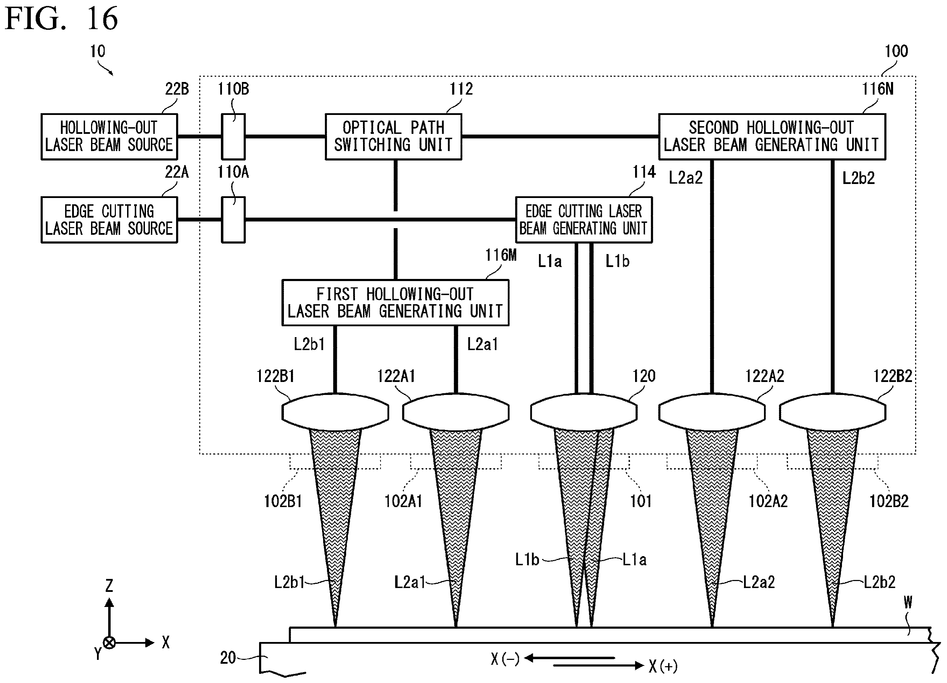

FIG. 16 is a view showing another example of a laser processing head that enables the processing in both the forward path and the backward path.

A laser processing head 100 of the present example differs from the laser processing head 100 shown in FIG. 15 in that one hollowing-out laser beam source 22B is shared by the first hollowing-out laser beam generating unit 116M and the second hollowing-out laser beam generating unit 116N.

The laser beam supplied from the hollowing-out laser beam source 22B is supplied to the first hollowing-out laser beam generating unit 116M or the second hollowing-out laser beam generating unit 116N via an optical path switching unit 112. Under the control of the control device 30, the optical path switching unit 112 switches the supply destination of the laser beam to the first hollowing-out laser beam generating unit 116M or the second hollowing-out laser beam generating unit 116N.

In the case of processing in the forward path (the processing feed in the X(-) direction), the control device 30 sets the supply destination of the laser beam to the first hollowing-out laser beam generating unit 116M. As a result, the first hollowing-out laser beamL2a1 for the forward path and the second hollowing-out laser beam L2b1 for the forward path are emitted from the first hollowing-out emission port 102A1 for the forward path and the second hollowing-out emission port 102B1 for the forward path, respectively.

In the case of processing in the backward path (the processing feed in the X(+) direction), the control device 30 sets the supply destination of the laser beam to the second hollowing-out laser beam generating unit 116N. As a result, the first hollowing-out laser beamL2a2 for the backward path and the second hollowing-out laser beam L2b2 for the backward path are emitted from the first hollowing-out emission port 102A2 for the backward path and the second hollowing-out emission port 102B2 for the backward path, respectively.

In this manner, also in the present configuration, the wiring layer removal groove C can be processed in the street St in both the forward path and the backward path.

In the examples shown in FIGS. 15 and 16, two hollowing-out emission ports are provided on both sides of the edge cutting emission port 101. Specifically, the first hollowing-out emission port 102A1 for the forward path and the second hollowing-out emission port 102B1 for the forward path as well as the first hollowing-out emission port 102A2 for the backward path and the second hollowing-out emission port 102B2 for the backward path are provided on both sides of the edge cutting emission port 101. However, a plurality of hollowing-out emission ports may be further provided.

### [Configuration for emitting plurality of hollowing-out laser beams from one condensing lens]

In the above-described embodiment, a plurality of hollowing-out laser beams are emitted from different condensing lenses. Specifically, the first hollowing-out laser beam L2a is emitted from the first hollowing-out condensing lens 122A, and the second hollowing-out laser beam L2b is emitted from the second hollowing-out condensing lens 122B. However, similarly to the edge cutting laser beam, the plurality of hollowing-out laser beams may be emitted from the same one condensing lens. For example, similarly to the edge cutting laser beam, it is possible to employ a configuration in which the diffractive optical element is used to generate the plurality of hollowing-out laser beams, which are then emitted from the one condensing lens. In this case, the processing width is adjusted by, for example, switching the diffractive optical element. For example, in the case of a configuration in which two types of processing widths can be selected, diffractive optical elements corresponding to the two types of processing widths are prepared, and the diffractive optical element is switched depending on the selected processing width to be used.

### [Second embodiment]

In the first embodiment, the desired wiring layer removal groove C is processed in the street St in a single processing feed. In contrast to this, in the present embodiment, a plurality of times of processing feeds (multiple passes) are applied to the wafer W to process the desired wiring layer removal groove C.

Here, a case in which a desired wiring layer removal groove C is processed in the wafer W dividedly in two times, that is, in a forward path (a first processing feed) and a backward path (a second processing feed), will be described as an example.

### [Laser processing head]

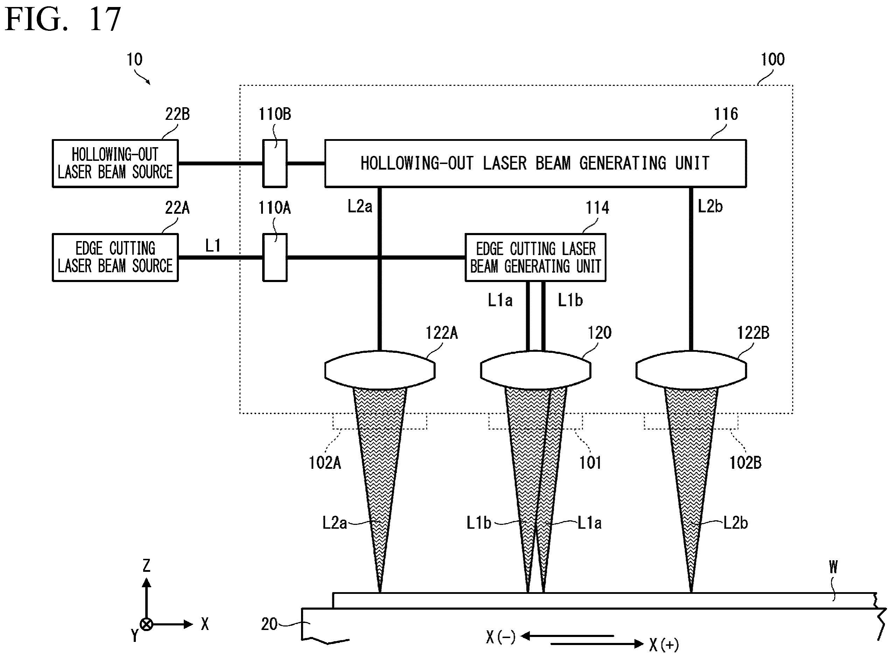

FIG. 17 is a view showing an example of a laser processing head provided in a workpiece processing apparatus of the present embodiment.

As shown in FIG. 17, hollowing-out emission ports 102A and 102B are disposed on both sides of an edge cutting emission port 101 in the processing feed direction. Hereinafter, as necessary, the hollowing-out emission port 102A disposed on the left side of FIG. 17 will be referred to as a "first hollowing-out emission port 102A" and the hollowing-out emission port 102B disposed on the right side will be referred to as a "second hollowing-out emission port 102B" to distinguish between the two.

A pair of edge cutting laser beams L1a and L1b generated by an edge cutting laser beam generating unit 114 are emitted from the edge cutting emission port 101 via an edge cutting condensing lens 120. The configuration of the edge cutting laser beam generating unit 114 is the same as that of the workpiece processing apparatus 10 of the first embodiment described above.

A first hollowing-out laser beam L2a generated by a hollowing-out laser beam generating unit 116 is emitted from the first hollowing-out emission port 102A via a first hollowing-out condensing lens 122A.

In addition, a second hollowing-out laser beam L2b generated by the hollowing-out laser beam generating unit 116 is emitted from the second hollowing-out emission port 102B via a second hollowing-out condensing lens 122B.

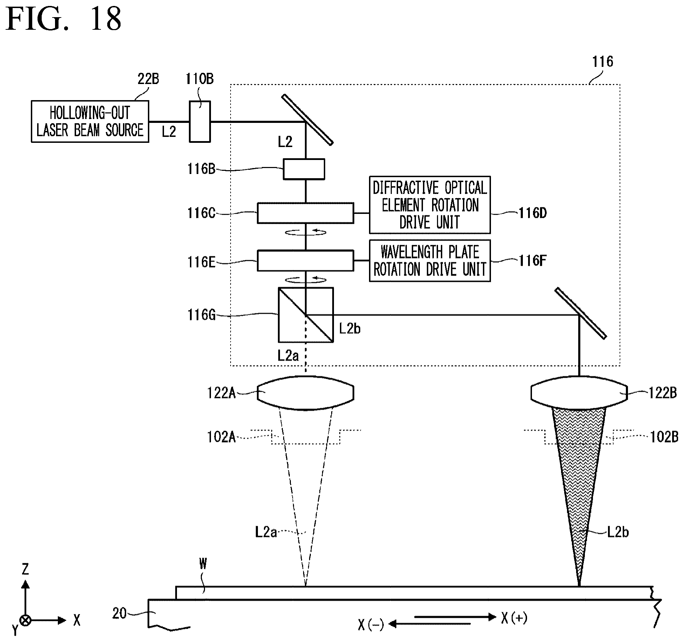

FIG. 18 is a schematic view showing an example of a configuration of the hollowing-out laser beam generating unit.

As shown in FIG. 18, the hollowing-out laser beam generating unit 116 includes a hollowing-out high-speed shutter 116B, a diffractive optical element 116C, a diffractive optical element rotation drive unit 116D, a 1/2 wavelength plate (a λ/2 plate) 116E, a wavelength plate rotation drive unit 116F, a polarizing beam splitter (PBS) 116G, and the like.

The hollowing-out high-speed shutter 116B is disposed on the optical path of a laser beam L2 that is incident on the hollowing-out laser beam generating unit 116 from a hollowing-out laser beam source 22B via a hollowing-out safety shutter 110B and opens and closes the optical path. The opening and closing of the hollowing-out high-speed shutter 116B is controlled by the control device 30.

In the present embodiment, a linearly polarized laser beam L2 that is polarized in a predetermined polarization direction is emitted from the hollowing-out laser beam source 22B.

The diffractive optical element 116C is disposed on the optical path of the laser beam L2 passing through the hollowing-out high-speed shutter 116B and is rotatably supported. The diffractive optical element 116C converts the shape of a beam spot of the hollowing-out laser beam into a predetermined shape. The converted shape is a non-circular shape. As an example, in the present embodiment, the shape is converted into a rectangular shape.

The diffractive optical element rotation drive unit 116D has an actuator and rotatably drives the diffractive optical element 116C. By rotating the diffractive optical element 116C using the diffractive optical element rotation drive unit 116D, the beam spots of the first hollowing-out laser beam L2a and the second hollowing-out laser beam L2b which are emitted from the first hollowing-out emission port 102A and the second hollowing-out emission port 102B are rotated around an optical axis. As a result, it is possible to adjust the processing width of the first hollowing-out laser beam L2a and the second hollowing-out laser beam L2b. The driving of the diffractive optical element rotation drive unit 116D is controlled by the control device 30.

The 1/2 wavelength plate 116E is disposed on the optical path of the laser beam L2 passing through the diffractive optical element 116C and is rotatably supported. As described above, a linearly polarized laser beam L2 that is polarized in a predetermined polarization direction is supplied from the hollowing-out laser beam source 22B of the present embodiment. Therefore, by rotating the 1/2 wavelength plate 116E, the polarization direction of the laser beam L2 is changed.

The wavelength plate rotation drive unit 116F rotates the 1/2 wavelength plate 116E between a first position and a second position. The second position is a position rotated 45 degrees from the first position. When the 1/2 wavelength plate 116E is rotated from the first position to the second position, the polarization direction of the laser beam L2 is rotated by 90 degrees. When the 1/2 wavelength plate 116E is set to the first position, the laser beam L2 polarized in a first polarization direction is emitted from the 1/2 wavelength plate 116E. On the other hand, when the 1/2 wavelength plate 116E is set to the second position, the laser beam L2 polarized in a second deflection direction is emitted from the 1/2 wavelength plate 116E. The second deflection direction is orthogonal to the first polarization direction.

The polarizing beam splitter 116G is disposed on the optical path of the laser beam L2 that has passed through the 1/2 wavelength plate 116E. The polarizing beam splitter 116G branches the incident beam into a transmission beam and a reflection beam according to the polarization state of the beam that is incident on the polarizing beam splitter 116G.
When the beam polarized in the first polarization direction is incident on the polarizing beam splitter 116G, the polarizing beam splitter 116G transmits the beam. In addition, when the beam polarized in the second deflection direction is incident on the polarizing beam splitter 116G, the polarizing beam splitter 116G reflects the beam.

As described above, when the 1/2 wavelength plate 116E is set to the first position, the laser beam L2 polarized in the first polarization direction is emitted from the 1/2 wavelength plate 116E. Therefore, when the 1/2 wavelength plate 116E is set to the first position, the laser beam L2 is transmitted through the polarizing beam splitter 116G.

On the other hand, when the 1/2 wavelength plate 116E is set to the second position, the laser beam L2 polarized in a second deflection direction is emitted from the 1/2 wavelength plate 116E. Therefore, when the 1/2 wavelength plate 116E is set to the second position, the laser beam L2 is reflected by the polarizing beam splitter 116G.

The laser beam transmitted through the polarizing beam splitter 116G is emitted as the first hollowing-out laser beam L2a from the first hollowing-out emission port 102A via the first hollowing-out condensing lens 122A.

On the other hand, the laser beam reflected by the polarizing beam splitter 116G is emitted as the second hollowing-out laser beam L2b from the second hollowing-out emission port 102B via the second hollowing-out condensing lens 122B.

According to the hollowing-out laser beam generating unit 116 of the present embodiment formed as described above, by rotating the 1/2 wavelength plate 116E using the wavelength plate rotation drive unit 116F, it is possible to selectively emit the hollowing-out laser beam (the first hollowing-out laser beam L2a or the second hollowing-out laser beam L2b) from the first hollowing-out emission port 102A or the second hollowing-out emission port 102B.

In addition, by rotating the diffractive optical element 116C using the diffractive optical element rotation drive unit 116D, it is possible to rotate the beam spots BS2a and BS2b of the first hollowing-out laser beam L2a and the second hollowing-out laser beam L2b around the optical axis. As a result, it is possible to adjust the processing width of the first hollowing-out laser beam L2a and the second hollowing-out laser beam L2b.

### [Processing of wiring layer removal groove]

As described above, in the present embodiment, the desired wiring layer removal groove C is processed in the wafer W dividedly in two times, that is, in the forward path and the backward path.

In the forward path, the first hollowing-out laser beam L2a is emitted from the first hollowing-out emission port 102A to perform the hollowing-out processing. On the other hand, in the backward path, the second hollowing-out laser beam L2b is emitted from the second hollowing-out emission port 102B to perform the hollowing-out processing. At this time, the inclination directions of the beam spots of the hollowing-out laser beams are set to opposite directions in the forward path and the backward path.

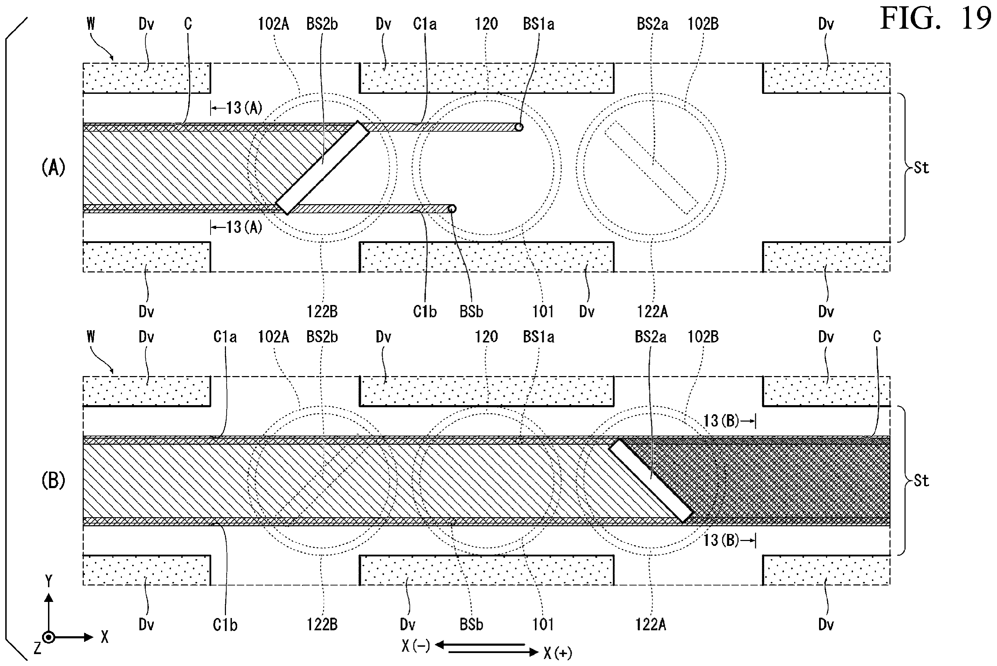

FIG. 19 is a conceptual view showing the processing of the wiring layer removal groove. FIG. 19A shows the processing state in the forward path. FIG. 19B shows the processing state on the backward path.

As shown in FIG. 19A, in the forward path (a first hollowing-out processing/a first step), the hollowing-out processing is performed by emitting the first hollowing-out laser beam L2a from the first hollowing-out emission port 102A located downstream of the edge cutting emission port 101 in the proceeding direction of the processing (X(+) direction in FIG. 19A). In the forward path, for example, the first hollowing-out laser beam L2a is rotated clockwise to adjust the processing width. By adjusting the processing width, the beam spot BS2a is inclined by a predetermined angle clockwise from a state in which the longitudinal direction of the beam spot is perpendicular to the processing feed direction.

In the backward path (a second hollowing-out processing/a second step), as shown in FIG. 19B, the second hollowing-out laser beam L2b is emitted from the second hollowing-out emission port 102B to perform the hollowing-out processing. In the forward path, the second hollowing-out laser beam L2b is rotated counterclockwise to adjust the processing width. By adjusting the processing width, the beam spot BS2b is inclined by a predetermined angle counterclockwise from a state in which the longitudinal direction of the beam spot is perpendicular to the processing feed direction.

In this manner, in the present embodiment, the hollowing-out processing is performed dividedly in two times, that is, in the forward path and the backward path, to process the wiring layer removal groove C in the streets St. At this time, the inclinations of the beam spots BS2a and BS2b of the hollowing-out laser beams L2a and L2b are set in the directions opposite to each other. As a result, it is possible to prevent the debris from adhering unevenly and to achieve high quality processing.

In the processing in the forward path, when the beam spot BS2a of the first hollowing-out laser beam L2a is inclined to perform the hollowing-out processing, the debris may be unevenly adhered to one side of the groove in the width direction (see FIG. 13A). However, in the backward path, since the hollowing-out processing is performed in a state in which the beam spot BS2b of the second hollowing-out laser beam L2b is inclined in the opposite direction, the unevenness is cancelled out, and the wiring layer removal groove C can be processed without any unevenness in the processed shape (see FIG. 13B).

### [Processing process of wafer]

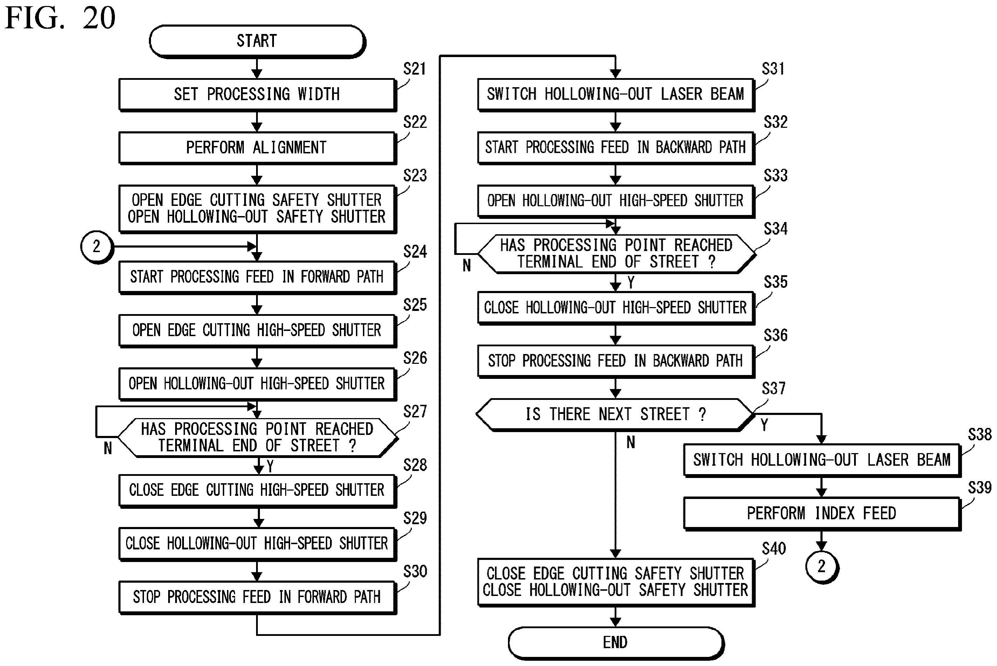

FIG. 20 is a flowchart showing a flow of a processing process of the wafer by the workpiece processing apparatus of the present embodiment.

It is assumed that the wafer W is already held on the table 20. In addition, it is assumed that the laser beam is supplied to the laser processing head 100 from the edge cutting laser beam source 22A and the hollowing-out laser beam source 22B. In addition, it is assumed that the edge cutting safety shutter 110A, the hollowing-out safety shutter 110B, the edge cutting high-speed shutter 114A, and the hollowing-out high-speed shutter 116B are closed.

First, setting of the processing width (the width of the wiring layer removal groove C) is performed (step S21). The control device 30 receives the setting of the processing width from a user (an operator).

The control device 30 performs setting of each unit such that the processing is performed with the set processing width. Specifically, the angle of the beam branching element 114B is set such that the edge cutting processing is performed with the set processing width. In addition, the angles of the diffractive optical element 116C is set such that the hollowing-out processing is performed with the set processing width. In addition, for the hollowing-out processing, setting is performed such that the first hollowing-out laser beam L2a is emitted from the first hollowing-out emission port 102A. Specifically, the 1/2 wavelength plate 116E is set to the first position.

After the processing width is set, alignment is performed (step S22). That is, the position of the processing is aligned with respect to the street St to be processed.

After the alignment, the edge cutting safety shutter 110A and the hollowing-out safety shutter 110B are opened (step S22). As a result, the laser beam L1 used for the edge cutting processing is introduced into the laser processing head 100 from the edge cutting laser beam source 22A. In addition, the laser beam L2 used for hollowing-out processing is introduced into the laser processing head 100 from the hollowing-out laser beam source 22B.

Since the edge cutting high-speed shutter 114A is closed, the edge cutting laser beams L1a and L1b are not emitted. Similarly, since the hollowing-out high-speed shutter 116B is closed, the first hollowing-out laser beam L2a and the second hollowing-out laser beam L2b are not emitted.

In this way, the preparation before the start of the processing is completed, and then the processing feed in the forward path is started (step S24). As a result, the processing feed is applied to the wafer W along the street St. The processing feed direction in the forward path is an X(-) direction in FIG. 1.

Next, the edge cutting high-speed shutter 114A is opened (step S25). As a result, the pair of edge cutting laser beams L1a and L1b are emitted from the edge cutting emission port 101 via the edge cutting condensing lens 120. The pair of edge cutting laser beams L1a and L1b emitted from the edge cutting emission port 101 are applied to the wafer W on the table 20. As a result, the two edge cut grooves C1a and C1b are processed along the street St. The proceeding direction of the processing is an X(+) direction in FIG. 1. The two edge cut grooves C1a and C1b are processed with a predetermined space and with a predetermined depth.

Next, the hollowing-out high-speed shutter 116B is opened (step S26). As a result, the first hollowing-out laser beam L2a is emitted from the first hollowing-out emission port 102A via the first hollowing-out condensing lens 122A. The first hollowing-out laser beam L2a is applied to a portion between the two edge cut grooves C1a and C1b which have been previously processed with the pair of edge cutting laser beams L1a and L1b. As a result, the portion between the two edge cut grooves C1a and C1b which have been previously processed is hollowing-out processed.

Thereafter, it is determined whether or not a processing point has reached the terminal end of the street St in the forward path (step S27). That is, it is determined whether or not the processing point has reached a processing end position in the forward path. When it is determined that the processing point has reached the processing end position in the forward path, first, the edge cutting high-speed shutter 114A is closed (step S28). As a result, the emission of the pair of edge cutting laser beams L1a and L1b is stopped. In addition, as a result, the edge cutting processing is ended. Next, the hollowing-out high-speed shutter 116B is closed (step S29). As a result, the emission of the first hollowing-out laser beam L2a is stopped. In addition, as a result, the hollowing-out processing (the first hollowing-out processing/the first step) is ended. Thereafter, the processing feed in the forward path is stopped (step S30).

Through the above series of steps, the processing in the forward path is ended. In succession, the processing in the backward path is performed.

First, the laser beam for the hollowing-out processing is switched (step S31). That is, setting is switched such that the second hollowing-out laser beam L2b is emitted from the second hollowing-out emission port 102B. This switching is performed as follows. First, the 1/2 wavelength plate 116E is rotated and set to the second position. As a result, setting is performed such that the second hollowing-out laser beam L2b is emitted from the second hollowing-out emission port 102B. In addition, the diffractive optical element 116C is rotated in the opposite direction to reverse the direction of the beam spot BS2b. That is, setting is performed such that the beam spot BS2b is inclined in a direction opposite to the inclination in the forward path.

After the switching setting is completed, the processing feed in the backward path is started (step S32). As a result, the processing feed is applied to the wafer W along the street St. The processing feed direction in the backward path is an X(+) direction in FIG. 1.

Next, the hollowing-out high-speed shutter 116B is opened (step S33). As a result, the second hollowing-out laser beam L2b is emitted from the second hollowing-out emission port 102B via the second hollowing-out condensing lens 122B. The second hollowing-out laser beam L2b emitted from the second hollowing-out emission port 102B is applied to the portion between the two edge cut grooves C1a and C1b which have been already processed. As a result, the portion between the two edge cut grooves C1a and C1b is further hollowing-out processed. The proceeding direction of the processing is an X(-) direction in FIG. 1.

Thereafter, it is determined whether or not the processing point has reached the terminal end of the street St in the backward path (the processing start position in the forward path) (step S34). When it is determined that the processing point has reached the terminal end of the street St in the backward path, the hollowing-out high-speed shutter 116B is closed (step S35). As a result, the emission of the second hollowing-out laser beam L2b is stopped. In addition, as a result, the hollowing-out processing (the second hollowing-out processing/the second step) is ended. Thereafter, the processing feed in the backward path is stopped (step S36).

Through the above series of steps, the processing in the backward path is ended. In addition, as a result, the processing of the wiring layer removal groove C on the street St to be processed is completed. Thereafter, it is determined whether or not there is a street St to be processed next (step S37).

In a case in which there is a street St to be processed next, the processing of the next street St is performed. In this case, first, the laser beam for the hollowing-out processing is switched (step S38). That is, setting is switched such that the first hollowing-out laser beam L2a is emitted from the first hollowing-out emission port 102A. Thereafter, the feed in the Y direction is applied to the wafer W (step S39). After the index feed, the processing of the next street St is performed in the same procedure (steps S24 to S37).

On the other hand, in a case in which there is no street St to be processed next, that is, in a case in which the processing for all the streets St is completed, the edge cutting safety shutter 110A and the hollowing-out safety shutter 110B are closed (step S40). Thereafter, the wafer W is retrieved from the table 20, and the processing process for the wafer W is completed.

In this manner, in the present embodiment, the hollowing-out processing is executed dividedly in two times, that is, in the forward path and the backward path, and in each time, the processing is performed in a state in which the inclinations of the beam spots BS2a and BS2b are set in opposite directions. As a result, it is possible to suppress the unevenness of the debris and to process a high-quality wiring layer removal groove C.

### [Modification example]

### [Number of times of hollowing-out processing]

In the above-described embodiment, the hollowing-out processing is performed twice in total in the forward path and the backward path. However, the hollowing-out processing may be executed a plurality of times by further applying a plurality of processing feeds. In this case, in the third and subsequent processing (the third and subsequent processing feeds), the direction (the inclination direction) of the beam spot is alternately switched to execute the hollowing-out processing. That is, the processing in which the beam spot is inclined in a first direction (a first step) and the processing in which the beam spot is inclined in a second direction opposite to the first direction (a second step) are alternately executed.

In addition, in a case in which the hollowing-out processing is executed a plurality of times, the intensity of the laser beam may be changed for each feed. As a result, it is possible to perform processing in which the intensity of the laser beam is changed depending on the layer to be removed, for example.

In addition, the number of times of the hollowing-out processing is not limited to an even number and may be an odd number. In this case, in the processing in the final processing feed, it is preferable to set the intensity of the laser beam to an intensity lower than that in the first processing so as to prevent the unevenness of the debris from occurring.

In a case in which the intensity of the hollowing-out laser beam is changed, the hollowing-out laser beam generating unit 116 is provided with a means for adjusting the intensity of the laser beam L2 (a means for modulating the intensity), for example, an acoustic optical deflector or the like.

### [Configuration of laser processing head]

In the above-described embodiment, one laser processing head includes two emission ports for the hollowing-out laser beam, but it is sufficient that the laser processing head includes at least one emission port for the hollowing-out laser beam. For example, in the configuration shown in FIG. 17, a configuration in which only the first hollowing-out emission port 102A is provided may be adopted.

### [Other embodiments]

### [Configuration of relative movement between table and laser processing head]

In the above-described embodiment, the table 20 moves in the X direction and the Y direction and rotates around the θ axis, and the laser processing head 100 moves in the Z direction, but the movement relationship between the table 20 and the laser processing head 100 is not limited to this. Any configuration may be used as long as the relative movement occurs between the two. For example, the laser processing head 100 may be fixed, and the table 20 may move in three directions, that is, X, Y, and Z directions, and rotate around the θ axis. Alternatively, the table 20 may move in the X direction and rotate around the θ axis, while the laser processing head 100 may move in the Y direction and the Z direction. In addition, the table 20 may rotate around the θ axis at a fixed position, and the laser processing head 100 may move in three directions, that is, X, Y, and Z directions. Furthermore, both the table 20 and the laser processing head 100 may move in three directions, that is, X, Y, and Z directions.

### [Laser processing unit]

In the above embodiment, a configuration in which the processing unit that performs the edge cutting processing and the processing unit that performs the hollowing-out processing are integrated with each other (a configuration in which the processing units are mounted on one laser processing head 100) has been described, but the processing unit that performs the edge cutting processing and the processing unit that performs hollowing-out processing may also be configured as separate independent units. For example, the processing unit that performs the edge cutting processing and the processing unit that performing the hollowing-out processing may be separated from each other and be able to move individually in the Z direction, or the like.

### [Shape of beam spot]

In the above-described embodiment, the shape of the beam spot of the hollowing-out laser beam is rectangular, but the shape of the beam spot of the hollowing-out laser beam is not limited to this. Any shape may be used as long as the width in the direction perpendicular to the processing feed direction (the processing width) can be changed in a case in which the beam spot is rotated around the optical axis. In other words, it is sufficient that the shape is non-circular. Therefore, for example, the same effect can be obtained even in a case in which the shape of the beam spot is linear, elliptical, or the like. In addition, as the aspect ratio of the shape is larger (the ratio of the longitudinal direction to the width direction of the shape is larger), the adjustment range of the processing width becomes larger. Therefore, as the shape is closer to a linear shape, the adjustment range of the processing width becomes larger.

### [Edge cutting processing]

In the above-described embodiment, the edge cutting processing and the hollowing-out processing are performed by the same apparatus, but the edge cutting processing and the hollowing-out processing may be performed by different apparatuses.

In addition, in the above-described embodiment, the edge cutting processing and the hollowing-out processing are performed consecutively for one street St, but the edge cutting process and the hollow cutting process may be performed separately.

### [Others]

In the above-described embodiment, a case in which the present invention is applied to an apparatus that removes a wiring layer including a Low-k film from a street before dicing of a semiconductor wafer that uses the Low-k film as an interlayer insulating film will be described as an example, but the application of the present invention is not limited to this. The present invention can be applied to all apparatuses that process the groove on the wafer by applying the laser beam from the laser processing head to the wafer on the table while moving the table and the laser processing head relatively in the processing feed direction.

In addition, in the above-described embodiment, the longitudinal direction of the beam spot of the hollowing-out laser beam is inclined in order to adjust the processing width, but the present invention can be applied to purposes other than adjusting the processing width. In other words, the present invention can be applied to all cases in which the processing is performed by inclining the longitudinal direction of the non-circular beam spot.

### EXPLANATION OF REFERENCES

10 Workpiece processing apparatus
20 Table
22A Edge cutting laser beam source
22B Hollowing-out laser beam source
22B1 First hollowing-out laser beam source
22B2 Second hollowing-out laser beam source
24 Microscope
26 Table drive unit
28 Head drive unit
30 Control device
30A Processor
30B Main storage device
30C Auxiliary storage device
30D Input device
30E Output device
100 Laser processing head
101 Edge cutting emission port
102A Hollowing-out emission port (first hollowing-out emission port)
102A1 Hollowing-out emission port (first hollowing-out emission port for forward path)
102A2 Hollowing-out emission port (first hollowing-out emission port for backward path)
102B Hollowing-out emission port (second hollowing-out emission port)
102B1 Hollowing-out emission port (second hollowing-out emission port for forward path)
102B2 Hollowing-out emission port (second hollowing-out emission port for backward path)
110A Edge cutting safety shutter
110B Hollowing-out safety shutter
110B1 First hollowing-out safety shutter
110B2 Second hollowing-out safety shutter
112 Optical path switching unit
114 Edge cutting laser beam generating unit
114A Edge cutting high-speed shutter
114B Beam branching element
114C Beam branching element rotation drive unit
116 Hollowing-out laser beam generating unit
116M Beam splitter
116B Hollowing-out high-speed shutter
116B1 First hollowing-out high-speed shutter
116B2 Second hollowing-out high-speed shutter
116C Diffractive optical element
116C1 First diffractive optical element
116C2 Second diffractive optical element
116D Diffractive optical element rotation drive unit
116E 1/2 wavelength plate
116F Wavelength plate rotation drive unit
116G Polarizing beam splitter
116M First hollowing-out laser beam generating unit
116N Second hollowing-out laser beam generating unit
120 Edge cutting condensing lens
122A First hollowing-out condensing lens
122A1 First hollowing-out condensing lens for forward path
122A2 First hollowing-out condensing lens for backward path
122B Second hollowing-out condensing lens
122B1 Second hollowing-out condensing lens for forward path
122B2 Second hollowing-out condensing lens for backward path
162B2 Second hollowing-out high-speed shutter
192B Second hollowing-out emission port
BS1a Beam spot of edge cutting laser beam
BS1b Beam spot of edge cutting laser beam
BS2 Beam spot of hollowing-out laser beam
BS2a Beam spot of first hollowing-out laser beam
BS2b Beam spot of second hollowing-out laser beam
C Groove (wiring layer removal groove)
C1a Groove (edge cut groove)
C1a Groove (edge cut groove)
D0 Processing width (maximum processing width)
D1 Processing width
D2 Processing width
DV Device
L1 Laser beam
L1a Laser beam (edge cutting laser beam)
L2 Laser beam (hollowing-out laser beam)
L2a Laser beam (hollowing-out laser beam, first hollowing-out laser beam)
L2a1 Laser beam (first hollowing-out laser beam for forward path)
L2a2 Laser beam (first hollowing-out laser beam for backward path)
L2b Laser beam (hollowing-out laser beam)
L2b Laser beam (hollowing-out laser beam, second hollowing-out laser beam)
L2b1 Laser beam (second hollowing-out laser beam for forward path)
L2b2 Laser beam (second hollowing-out laser beam for backward path)
OL1 Symmetric axis
OL2 Optical axis
St Street
W Wafer

## Claims

1. A workpiece processing method for performing hollowing-out processing of a portion between two grooves formed in a workpiece, the method comprising:
a first step of applying a first laser beam having a non-circular beam spot to the portion between the two grooves on the workpiece to which a processing feed is applied relatively along the two grooves to perform hollowing-out processing of the portion between the two grooves; and
a second step of applying a second laser beam having a non-circular beam spot to the portion between the two grooves which is hollowed out with the first laser beam on the workpiece to which a processing feed is applied relatively along the two grooves to further perform hollowing-out processing of the portion between the two grooves,
wherein, in the first step, the first laser beam is applied in a state in which a longitudinal direction of the beam spot is inclined with respect to a proceeding direction of the processing such that a processing width corresponds to a space between the two grooves, and
wherein, in the second step, the second laser beam is applied in a state in which a longitudinal direction of the beam spot is inclined in a direction opposite to that of the first laser beam with respect to a proceeding direction of the processing such that a processing width corresponds to a space between the two grooves.

2. The workpiece processing method according to claim 1, wherein the beam spot of the first laser beam and the beam spot of the second laser beam are inclined in directions opposite to each other and at the same angle.

3. The workpiece processing method according to claim 1 or 2, wherein, in a case in which the processing feed is applied at least twice,
the first step is executed in a first processing feed, and
the second step is executed in a second processing feed.

4. The workpiece processing method according to claim 3, wherein the first step and the second step are alternately executed in third and subsequent processing feeds.

5. The workpiece processing method according to claim 4, wherein, in a case in which the processing feed is applied an odd number of times, the first step is executed in a state in which intensity of the first laser beam is set lower in a last processing feed than in the first processing feed.

6. The workpiece processing method according to claim 1 or 2, wherein intensities of the first laser beam and the second laser beam are changed for each processing feed.

7. The workpiece processing method according to claim 1 or 2, wherein the first step and the second step are executed in a single processing feed.

8. The workpiece processing method according to claim 7, wherein the first step and the second step are executed in a single processing feed while the first laser beam and the second laser beam are emitted from the same condensing lens.

9. The workpiece processing method according to claim 7, wherein the first step and the second step are executed in a single processing feed while the first laser beam and the second laser beam are emitted from different condensing lenses.

10. The workpiece processing method according to claim 1 or 2, further comprising a step of applying a pair of third laser beams on the workpiece to which a processing feed is applied relatively to process the two grooves.

11. The workpiece processing method according to claim 1 or 2, wherein the beam spots of the first laser beam and the second laser beam are linear, rectangular, or elliptical.
